(19) Europäisches Patentamt

European Patent Office

Office européen des brevets

(11) **EP 2 663 174 B1**

(12) **EUROPEAN PATENT SPECIFICATION**

(45) Date of publication and mention
of the grant of the patent:
**19.09.2018 Bulletin 2018/38**

(51) Int Cl.:
***H05K 13/04*** *(2006.01)*

(21) Application number: **13001801.3**

(22) Date of filing: **08.04.2013**

(54) **Working apparatus for component or board**

Arbeitsvorrichtung für Komponente oder Platte

Appareil d'usinage de composants ou de carton

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **11.05.2012 JP 2012109874**

(43) Date of publication of application:
**13.11.2013 Bulletin 2013/46**

(73) Proprietor: **Yamaha Hatsudoki Kabushiki Kaisha
Iwata-shi, Shizuoka 438-8501 (JP)**

(72) Inventors:
• **Suzuki, Yasuhiro**
**Iwata-shi, Shizuoka-KEN, 438-850 (JP)**
• **Torii, Masanori**
**Iwata-shi, Shizuoka-KEN, 438-850 (JP)**

(74) Representative: **Müller-Boré & Partner
Patentanwälte PartG mbB
Friedenheimer Brücke 21
80639 München (DE)**

(56) References cited:
**EP-A1- 1 583 412      WO-A1-2005/120147
US-A1- 2009 252 400**

**Description**

BACKGROUND OF THE INVENTION

Field of the Invention

The present invention relates to a working apparatus for a component or a board, and more particularly, it relates to a working apparatus for a component or a board including a head unit with imaging portions.

Description of the Background Art

A component mounting apparatus or the like including a head unit with imaging portions is known in general, as disclosed in Japanese Patent Laying-Open No. 2005-347555, for example.

Japanese Patent Laying-Open No. 2005-347555 discloses a component mounting apparatus including a component placing head with two cameras (imaging portions) and component suction nozzles (working mechanism portions) arranged between these cameras, capable of being moved to an arbitrary position on a board. In this component placing head of the component mounting apparatus, the component suction nozzles between the cameras are arranged on a straight line (X-axis) passing through the centers of the two cameras, and the rotation angle (yawing value) of the component placing head with respect to the X-axis in the plane (X-Y plane) of the board can be grasped with the two cameras. In this case, the amounts of displacement (displacement in a direction Y) of the component suction nozzles from the X-axis are obtained on the basis of horizontal distances from the centers of the cameras to the component suction nozzles and the rotation angle of the component placing head. Thus, even if an X-axis frame and a Y-axis frame supporting the component placing head are distorted, the component placing head is moved while the amounts of displacement corresponding to the rotation angle of the component placing head rotated due to the distortion are taken into consideration, and hence the component suction nozzles are accurately moved to component mounting positions.

In the component placing head of the component mounting apparatus described in Japanese Patent Laying-Open No. 2005-347555, the component suction nozzles are arranged on the straight line (X-axis) passing through the centers of the two cameras, so that the amounts of displacement (displacement in the direction Y) of the component suction nozzles are easily grasped on the basis of center-to-center distances between the cameras and the component suction nozzles and the rotation angle of the component placing head. However, in the component placing head in which the component suction nozzles are arranged at positions displaced from the straight line passing through the centers of the two cameras, for example, it is difficult to grasp the amounts of displacement of the component suction nozzles by directly applying the aforementioned method. Therefore, according to the structure described in Japanese Patent Laying-Open No. 2005-347555, the component suction nozzles (working mechanism portions) cannot be accurately moved to the component mounting positions (working positions) in the case of the component placing head in which the component suction nozzles (working mechanism portions) are not arranged on the straight line passing through the centers of the imaging portions.

EP 1 583 412 A1 discloses a component mounting apparatus comprising an X-Y robot having a component holding member for holding an electronic component, for mounting the held electronic component in a component placing position of a circuit board after moving in an X-axis direction and a Y-axis direction that are perpendicular to each other. The mounting apparatus further comprises a fixed board recognition camera that is provided for the X-Y robot, for picking up an image of a board mark on the circuit board, and a component recognition camera for picking up an image of the electronic component held by the component holding member. And, the mounting apparatus further comprises a camera reference mark arranged in vicinity of the component recognition camera, and a control unit for correcting the component placing position based on position information of the camera reference mark obtained by picking-up the camera reference mark by means of the board recognition camera.

US 2009/252400 A1 discloses a method in order to recognize grid-like reference marks on a jig plate positioned in a mounting area by means of a substrate recognizing camera respectively, to obtain a positional shift amount of a mounting head with respect to XY coordinates on an apparatus of each of the reference marks, and to correct a mounting position, thereby carrying out a mounting operation. To this end, a jig component positioned and mounted sequentially on each of the reference marks formed on the jig plate by means of a nozzle head is recognized by the substrate recognizing camera, a shift amount of XY coordinates acquired by the camera recognition of the jig component from XY coordinates on the apparatus of the corresponding reference mark is obtained as corrected data on the nozzle head with respect to the reference mark, and a correction is carried out based on the corrected data when an electronic component is to be mounted on a substrate by means of the nozzle head.

SUMMARY OF THE INVENTION

The present invention has been proposed in order to solve the aforementioned problem, and an object of the present invention is to provide a working apparatus for a component or a board and a component mounting apparatus each capable of accurately moving a working mechanism portion to a working position even if the working mechanism portion is not arranged on a straight line passing through the centers of imaging portions.

In order to attain the aforementioned object, a working apparatus for a component or a board according to an aspect of the present invention includes a head unit including a first imaging portion, a second imaging portion, and a working mechanism portion arranged at a position other than on a straight line passing through the center of the first imaging portion and the center of the second imaging portion in a plan view and a control portion performing control of moving the head unit in a horizontal plane, while the control portion is configured to perform control of correcting the center position of the working mechanism portion on the basis of the first amount of movement displacement of the actual position coordinates of the center position of the first imaging portion with respect to the theoretical position coordinates of the center position of the first imaging portion, the second amount of movement displacement of the actual position coordinates of the center position of the second imaging portion with respect to the theoretical position coordinates of the center position of the second imaging portion, and the positional interrelation between the first imaging portion, the second imaging portion, and the working mechanism portion when moving the head unit.

In the working apparatus for a component or a board according to the aspect of the present invention, as hereinabove described, the control portion is configured to perform control of correcting the center position of the working mechanism portion on the basis of the first amount of movement displacement of the actual position coordinates of the center position of the first imaging portion with respect to the theoretical position coordinates of the center position of the first imaging portion, the second amount of movement displacement of the actual position coordinates of the center position of the second imaging portion with respect to the theoretical position coordinates of the center position of the second imaging portion, and the positional interrelation between the first imaging portion, the second imaging portion, and the working mechanism portion when moving the head unit, whereby the control portion can properly correct the center position of the working mechanism portion on the basis of the first amount of movement displacement, the second amount of movement displacement, and the positional interrelation between the first imaging portion, the second imaging portion, and the working mechanism portion when moving the head unit even if the head unit in which the working mechanism portion is not arranged on the straight line passing through the center of the first imaging portion and the center of the second imaging portion is used. Thus, the control portion can accurately move the working mechanism portion to a working position for the component or the board.

In the aforementioned working apparatus for a component or a board according to the aspect, intersection coordinates at which a circle having a first radius distance between the center position of the first imaging portion and the center position of the working mechanism portion as a radius, employing the center position of the first imaging portion of the actual position coordinates having the first amount of movement displacement as a center and a circle having a second radius distance between the center position of the second imaging portion and the center position of the working mechanism portion as a radius, employing the center position of the second imaging portion of the actual position coordinates having the second amount of movement displacement as a center intersect with each other are the center position of the working mechanism portion obtained on the basis of the positional interrelation, and the control portion is configured to perform control of correcting the center position of the working mechanism portion on the basis of a first correction amount being a difference in a first direction between the theoretical position coordinates of the center position of the working mechanism portion and the intersection coordinates and a second correction amount being a difference in a second direction orthogonal to the first direction between the theoretical position coordinates of the center position of the working mechanism portion and the intersection coordinates. According to this structure, the control portion can easily specify (estimate) the center position (intersection coordinates) of the displaced working mechanism portion on the basis of the positional interrelation between the first imaging portion, the second imaging portion, and the working mechanism portion, and hence the control portion can easily obtain the first and second correction amounts corresponding to the differences between the displaced actual position coordinates and the theoretical position coordinates. Thus, the control portion can accurately move the working mechanism portion to the working position for the component or the board while taking the first and second correction amounts into consideration.

In the aforementioned structure in which the control portion performs control of correcting the center position of the working mechanism portion on the basis of the first and second correction amounts, the control portion is preferably configured to perform control of moving the center position of the working mechanism portion to position coordinates obtained by subtracting the first correction amount in the first direction and the second correction amount in the second direction from the theoretical position coordinates of the center position of the working mechanism portion, respectively when moving the head unit. According to this structure, the center position of the working mechanism portion can be easily corrected with the first and second correction amounts in arithmetic processing performed by the control portion, and hence the working mechanism portion of the head unit can be easily moved to the working position after correction.

In the aforementioned structure in which the control portion performs control of correcting the center position of the working mechanism portion on the basis of the first and second correction amounts, the first amount of movement displacement preferably includes the first amount of displacement in the first direction of the actual position coordinates of the center position of the first imaging portion from the theoretical position coordinates of the center position of the first imaging portion and the second amount of displacement in the second direction of the actual position coordinates of the center position of the first imaging portion from the theoretical position coordinates of the center position of the first imaging portion, the second amount of movement displacement preferably includes the third amount of displacement in the first direction of the actual position coordinates of the center position of the second imaging portion from the theoretical position coordinates of the center position of the second imaging portion and the fourth amount of displacement in the second direction of the actual position coordinates of the center position of the second imaging portion from the theoretical position coordinates of the center position of the second imaging portion, and the intersection coordinates serving as the center position of the working mechanism portion are preferably calculated on the basis of a first relational expression satisfied between the intersection coordinates, the theoretical position coordinates of the first imaging portion, the first amount of displacement, the second amount of displacement, and the first radius distance and a second relational expression satisfied between the intersection coordinates, the theoretical position coordinates of the second imaging portion, the third amount of displacement, the fourth amount of displacement, and the second radius distance. According to this structure, the center position (intersection coordinates) of the working mechanism portion in the horizontal plane can be easily calculated utilizing numerical calculation or the like. Therefore, the first and second correction amounts corresponding to the differences between the intersection coordinates (actual position coordinates) and the theoretical position coordinates used in the control of correcting the center position of the working mechanism portion can be accurately obtained.

In the aforementioned structure in which the first amount of movement displacement includes the first amount of displacement and the second amount of displacement and the second amount of movement displacement includes the third amount of displacement and the fourth amount of displacement, the first relational expression is preferably an equation of a circle defined with the coordinate position in the first direction of the intersection coordinates, a first horizontal distance calculated on the basis of the theoretical position coordinate in the first direction of the first imaging portion and the first amount of displacement, the coordinate position in the second direction of the intersection coordinates, a first vertical distance calculated on the basis of the theoretical position coordinate in the second direction of the first imaging portion and the second amount of displacement, and the first radius distance, and the second relational expression is preferably an equation of a circle defined with the coordinate position in the first direction of the intersection coordinates, a second horizontal distance calculated on the basis of the theoretical position coordinate in the first direction of the second imaging portion and the third amount of displacement, the coordinate position in the second direction of the intersection coordinates, a second vertical distance calculated on the basis of the theoretical position coordinate in the second direction of the second imaging portion and the fourth amount of displacement, and the second radius distance. According to this structure, the first and second relational expressions defined as circle equations are solved together, whereby the center position (intersection coordinates) of the working mechanism portion corresponding to a point at which the two circles intersect with each other can be easily obtained.

In this case, the intersection coordinates are preferably calculated by solving the first relational expression and the second relational expression together, and one set of the intersection coordinates effective in control processing for correcting the center position of the working mechanism portion is preferably selected from two sets of the intersection coordinates obtained by solving the first relational expression and the second relational expression together on the basis of the positional interrelation between the first imaging portion, the second imaging portion, and the working mechanism portion. According to this structure, a solution (intersection coordinates) ineffective in the control processing for correcting the center position of the working mechanism portion can be easily eliminated, and hence the center position (intersection coordinates) of the working mechanism portion effective in the control processing can be accurately acquired.

In the aforementioned working apparatus for a component or a board according to the aspect, the control portion is preferably configured to perform control of correcting the center position of the working mechanism portion and moving the head unit on the basis of the first amount of movement displacement, the second amount of movement displacement, and the positional interrelation between the first imaging portion, the second imaging portion, and the working mechanism portion when an operation on the component or the board is performed with the head unit. According to this structure, it is only necessary for the control portion to calculate the correction amounts of the center position of the working mechanism portion each time the operation on the component or the board is performed. Thus, as compared with a case where correction amounts regarding a large number of working positions are obtained in a matrix manner to cover an entire region in the horizontal plane and are stored as data in the working apparatus, for example, it is not necessary to hold a large amount of data, so that the amount of data held in the working apparatus can be significantly reduced.

In the aforementioned structure in which the control portion performs control of correcting the center position of the working mechanism portion and moving the head unit when performing an operation on the component or the board, the control portion is preferably configured to perform control of correcting the center position of the working mechanism portion and moving the head unit on the basis of the first amount of movement displacement, the second amount of movement displacement, and the positional interrelation between the first imaging portion, the second imaging portion, and the working mechanism portion each time a single operation on the individual component or the individual board is performed. According to this structure, the control of correcting the center position of the working mechanism portion and moving the head unit is performed once in every operation on the individual component or the individual board, and hence the working mechanism portion can be accurately moved to the corresponding working position each time an operation is performed on each component or each board at a different working position.

In the aforementioned structure in which the control portion performs control of correcting the center position of the working mechanism portion and moving the head unit when performing an operation on the component or the board, the control portion is preferably configured to perform arithmetic processing for correcting the center position of the working mechanism portion and perform control of moving the head unit on the basis of the first amount of movement displacement, the second amount of movement displacement, and the positional interrelation between the first imaging portion, the second imaging portion, and the working mechanism portion. According to this structure, the head unit can be moved actually while the arithmetic processing for correcting the center position of the working mechanism portion is performed, and hence the takt time required for an operation on the component or the board can be inhibited from increasing due to the arithmetic processing.

The aforementioned working apparatus for a component or a board according to the aspect further includes a correction table to which the control portion refers for the amount of displacement of the actual position coordinates of the center position of the first imaging portion with respect to the theoretical position coordinates of the center position of the first imaging portion and the amount of displacement of the actual position coordinates of the center position of the second imaging portion with respect to the theoretical position coordinates of the center position of the second imaging portion when moving the head unit in the horizontal plane, and the control portion is configured to perform control of correcting the center position of the working mechanism portion on the basis of the first amount of movement displacement regarding the center position of the first imaging portion grasped on the basis of the correction table, the second amount of movement displacement regarding the center position of the second imaging portion grasped on the basis of the correction table, and the positional interrelation between the first imaging portion, the second imaging portion, and the working mechanism portion when moving the head unit. According to this structure, the arithmetic processing for correcting the center position of the working mechanism portion can be promptly performed on the basis of the first amount of movement displacement, the second amount of movement displacement, and the positional interrelation between the first imaging portion, the second imaging portion, and the working mechanism portion, effectively utilizing the correction table.

In this case, the correction table preferably includes a first correction table in which the amount of displacement of the actual position coordinates of the center position of the first imaging portion with respect to the theoretical position coordinates of the center position of the first imaging portion is defined and a second correction table in which the amount of displacement of the actual position coordinates of the center position of the second imaging portion with respect to the theoretical position coordinates of the center position of the second imaging portion is defined, and the control portion is preferably configured to perform control of correcting the center position of the working mechanism portion on the basis of the first amount of movement displacement regarding the center position of the first imaging portion calculated with the first correction table, the second amount of movement displacement regarding the center position of the second imaging portion calculated with the second correction table, and the positional interrelation between the first imaging portion, the second imaging portion, and the working mechanism portion when moving the head unit. According to this structure, the first amount of movement displacement can be easily calculated with the first correction table, and the second amount of movement displacement can be easily calculated with the second correction table.

The aforementioned working apparatus for a component or a board according to the aspect further includes a moving mechanism portion so configured that the head unit is movable in the horizontal plane, and the control portion is configured to perform control of correcting the center position of the working mechanism portion on the basis of the first amount of movement displacement regarding the center position of the first imaging portion resulting from the distortion of the moving mechanism portion, the second amount of movement displacement regarding the center position of the second imaging portion resulting from the distortion of the moving mechanism portion, and the positional interrelation between the first imaging portion, the second imaging portion, and the working mechanism portion when moving the head unit by the moving mechanism portion. According to this structure, even if the moving mechanism portion moving the head unit is distorted, the center position of the working mechanism portion can be properly corrected on the basis of the first and second amounts of movement displacement resulting from rotation of the head unit due to the distortion of the moving mechanism portion and the positional interrelation between the first imaging portion, the second imaging portion, and the working mechanism portion when the head unit is moved.

In this case, the moving mechanism portion preferably includes a rail member extending in a first direction to move the head unit along the first direction, and the control portion is preferably configured to perform control of correcting the center position of the working mechanism portion on the basis of the first amount of movement displacement regarding the center position of the first imaging portion resulting from the deformation of the rail member in a second direction orthogonal to the first direction, the second amount of movement displacement regarding the center position of the second imaging portion resulting from the deformation of the rail member in the second direction, and the positional interrelation between the first imaging portion, the second imaging portion, and the working mechanism portion when moving the head unit. Thus, even if the rail member extending in the first direction is deformed such as undulated in the second direction, the center position of the working mechanism portion can be properly corrected on the basis of the first and second amounts of movement displacement resulting from the rotation of the head unit moving on the rail member due to the deformation of the rail member and the positional interrelation between the first imaging portion, the second imaging portion, and the working mechanism portion when the head unit is moved.

In the aforementioned working apparatus for a component or a board according to the aspect, a plurality of working mechanism portions are preferably provided on the head unit, and the control portion is preferably configured to perform control of correcting the center position of each of the plurality of working mechanism portions on the basis of the first amount of movement displacement regarding the center position of the first imaging portion, the second amount of movement displacement regarding the center position of the second imaging portion, and the positional interrelation between the first imaging portion, the second imaging portion, and the working mechanism portion when moving the head unit. According to this structure, also when the head unit has the plurality of working mechanism portions, the control portion performs control of correcting the respective center positions of the working mechanism portions and moving the head unit, so that the working mechanism portions corresponding to respective working positions can be accurately moved with respect to all operations performed with this head unit.

In the aforementioned structure in which the control portion performs control of correcting the center position of the working mechanism portion on the basis of the first and second correction amounts, the head unit is preferably configured to be movable along the first direction, the second imaging portion is preferably arranged at a different position in the second direction orthogonal to the first direction with respect to the first imaging portion, the first amount of movement displacement preferably includes the first amount of displacement in the first direction of the actual position coordinates of the center position of the first imaging portion from the theoretical position coordinates of the center position of the first imaging portion and the second amount of displacement in the second direction of the actual position coordinates of the center position of the first imaging portion from the theoretical position coordinates of the center position of the first imaging portion, the second amount of movement displacement preferably includes the third amount of displacement in the first direction of the actual position coordinates of the center position of the second imaging portion from the theoretical position coordinates of the center position of the second imaging portion and the fourth amount of displacement in the second direction of the actual position coordinates of the center position of the second imaging portion from the theoretical position coordinates of the center position of the second imaging portion, and the intersection coordinates serving as the center position of the working mechanism portion are preferably calculated on the basis of a first relational expression satisfied between the intersection coordinates, the theoretical position coordinates of the first imaging portion, the first amount of displacement, the second amount of displacement, and the first radius distance and a second relational expression satisfied between the intersection coordinates, the theoretical position coordinates of the second imaging portion, the third amount of displacement, the fourth amount of displacement, and the second radius distance. When the head unit in which the second imaging portion is arranged at the different position in the second direction with respect to the first imaging portion is moved, the center position of the working mechanism portion can be properly corrected on the basis of the first amount of movement displacement, the second amount of movement displacement, and the positional interrelation between the first imaging portion, the second imaging portion, and the working mechanism portion. Consequently, the working mechanism portion can be accurately moved to the working position for the component or the board.

The foregoing and other objects, features, aspects and advantages of the present invention will become more apparent from the following detailed description of the present invention when taken in conjunction with the accompanying drawings.

BRIEF DESCRIPTION OF THE DRAWINGS

Fig. 1 is a plan view showing the structure of a surface mounter according to an embodiment of the present invention;
Fig. 2 is a side elevational view of the surface mounter according to the embodiment of the present invention, as viewed along a depth direction (arrow Y2);
Fig. 3 is a block diagram showing the control structure of the surface mounter according to the embodiment of the present invention;
Fig. 4 illustrates a state where a head unit in motion is rotationally moved in a horizontal plane due to the distortion of a guide rail in the surface mounter according to the embodiment of the present invention;

Fig. 5 illustrates a method for calculating the amounts of displacement (correction amounts) of a suction nozzle from the theoretical position coordinates thereof associated with the displacement of the head unit shown in Fig. 4;
Fig. 6 illustrates a jig plate used when the amount of distortion of the surface mounter according to the embodiment of the present invention is previously measured with a main camera and an auxiliary camera;
Fig. 7 illustrates correction tables prepared on the basis of the amount of distortion measured on the basis of the jig plate and stored in a memory in the surface mounter according to the embodiment of the present invention;
Fig. 8 illustrates the flow of processing performed by a central processing unit to previously measure the amount of distortion of the surface mounter according to the embodiment of the present invention with the main camera and the auxiliary camera; and
Fig. 9 illustrates the flow of processing performed by the central processing unit to mount electronic components by driving the head unit in the surface mounter according to the embodiment of the present invention.

DESCRIPTION OF THE PREFERRED EMBODIMENTS

An embodiment of the present invention is now described with reference to the drawings.

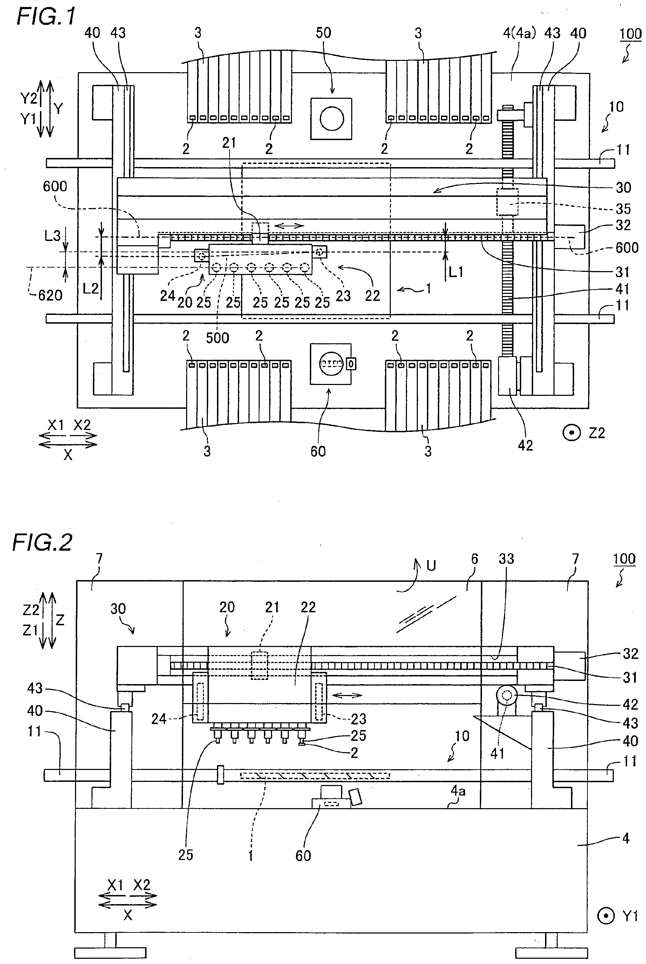

First, the structure of a surface mounter 100 according to the embodiment of the present invention is described with reference to Figs. 1 to 7. The surface mounter 100 is an example of the "working apparatus for a component or a board" or the "component mounting apparatus" in the present invention.

The surface mounter 100 according to the embodiment of the present invention is an apparatus for mounting electronic components 2 on a printed board (wiring board) 1, as shown in Figs. 1 and 2. The surface mounter 100 includes a base 4, a board conveying portion 10 provided on the base 4 (front side in the plane of the figure), a head unit 20 movable along an X-Y plane (plane of the figure) above the board conveying portion 10, a support portion 30 supporting the head unit 20 to be movable in a direction X, and a moving mechanism 40 moving the support portion 30 in a direction Y, as shown in Fig. 1. The electronic components 2 are examples of the "component" in the present invention. The direction X and the direction Y are examples of the "first direction" and the "second direction" in the present invention, respectively.

A plurality of rows of tape feeders 3 to supply the electronic components 2 are arranged on both sides (Y1 and Y2 sides) of the board conveying portion 10. The tape feeders 3 hold reels (not shown) on which tapes holding a plurality of electronic components 2 at prescribed intervals are wound. The reels are rotated to send out the tapes, whereby the electronic components 2 are supplied from forward end portions of the tape feeders 3. The head unit 20 acquires the electronic components 2 from the tape feeders 3, and has a function of mounting the electronic components 2 on the printed board 1 placed on the board conveying portion 10. The electronic components 2 are small pieces of electronic components such as ICs, transistors, capacitors, and resistors.

In the surface mounter 100, a cover 6 is attached to a casing 7 provided on the base 4, as shown in Fig. 2. The cover 6 is configured to pivot upward (along arrow U) relative to the casing 7, and is so configured that a user (operator) can access the board conveying portion 10. In Fig. 2, the internal structure that is covered with the casing 7 and unseen from the outside under normal circumstances is also shown by solid lines for convenience of illustration.

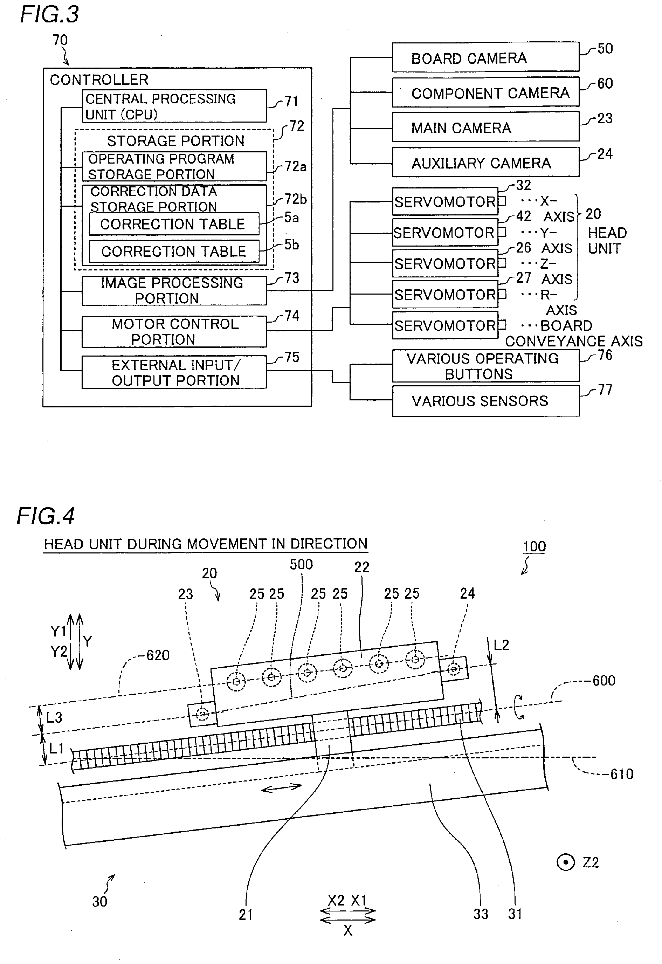

As shown in Fig. 3, a controller 70 to perform operational control of each portion of a mounter body is built in the surface mounter 100. The controller 70 is mainly constituted by a central processing unit (CPU) 71, a storage portion 72 (an operating program storage portion 72a and a correction data storage portion 72b), an image processing portion 73, a motor control portion 74, and an external input/output portion 75. Components constituting the controller 70 are later described in detail. The central processing unit 71 is an example of the "control portion" in the present invention.

The board conveying portion 10 includes a pair of conveyor portions 11 extending in the direction X that is the conveying direction of the printed board 1, as shown in Fig. 1. The conveyor portions 11 are provided with a plurality of board sensors (not shown) detecting the conveying condition of the printed board 1. Thus, the printed board 1 held by the conveyor portions 11 is conveyed on the basis of the detection results of the board sensors. The board conveying portion 10 is internally provided with a clamp mechanism holding the printed board 1 being conveyed while stopping the printed board 1 at a stop position during mounting of the components.

The support portion 30 has a ball screw shaft 31 extending in the direction X, a servomotor 32 rotating the ball screw shaft 31, and a guide rail 33 extending along the ball screw shaft 31, as shown in Fig. 2. The head unit 20 has a slide guide portion 21 attached with a ball nut (not shown) receiving the ball screw shaft 31. Thus, the head unit 20 is moved back and forth along the direction X following the rotation of the ball screw shaft 31 while the slide guide portion 21 is guided by the guide rail 33. The support portion 30 is an example of the "moving mechanism portion" in the present invention, and the guide rail 33 is an example of the "rail member" in the present invention.

The support portion 30 is configured to be movable in the direction Y substantially orthogonal to the direction X in a state where the same is placed on the moving mechanism 40 fixed onto the base 4. Specifically, the moving mechanism 40 has a ball screw shaft 41 extending in the direction Y, a servomotor 42 rotating the ball screw shaft 41, and a pair of guide rails 43 extending along the ball screw shaft 41, as shown in Fig. 1. The guide rails 43 movably support both end portions (in the direction X) of the support portion 30. The support portion 30 is provided with a ball nut 35 receiving the ball screw shaft 41. Thus, the ball nut 35 is moved back and forth in the direction Y following the rotation of the ball screw shaft 41 while the support portion 30 is guided by the guide rails 43. Therefore, the head unit 20 is configured to be capable of moving to an arbitrary position along the X-Y plane over the base 4 by rotating the ball screw shafts 31 and 41.

The head unit 20 has a mounting head 22 fixed to the slide guide portion 21 and a main camera 23 and an auxiliary camera 24 respectively attached to both end portions (in the direction X) of the mounting head 22, as shown in Fig. 2. As shown in Fig. 1, the head unit 20 is so configured that the distance L1 (along arrow Y1) of the main camera 23 from the ball screw shaft 31 (X-axis line 600) and the distance L2 (along arrow Y1) of the auxiliary camera 24 from the ball screw shaft 31 are different from each other (L1 < L2). In other words, suction nozzles 25 are not arranged on a straight line 500 passing through the center of the main camera 23 and the center of the auxiliary camera 24. The mounting head 22 has a plurality of (six) suction nozzles 25 provided on the lower surface side (Z1 side in Fig. 2) opposed to the printed board 1. As shown in Fig. 1, each of the suction nozzles 25 is arranged at a position offset by a distance L3 along arrow Y1 from the position of the main camera 23 in the direction Y. As shown in Fig. 2, each of the suction nozzles 25 has a function of holding an electronic component 2 by suctioning the electronic component 2 with negative pressure generated in a forward end portion of the nozzle by a negative pressure generator (not shown). The main camera 23 and the auxiliary camera 24 are examples of the "first imaging portion" and the "second imaging portion" in the present invention, respectively. The suction nozzles 25 are examples of the "working mechanism portion" in the present invention.

Even if the guide rail 33 that is an elongated member is accurately designed and manufactured, the shape of the guide rail 33 is slightly distorted. In other words, the guide rail 33 is not completely straight along the direction X, but has undulation as a whole with small displacement in the direction Y. When the slide guide portion 21 moves in the direction X while sliding along the guide rail 33 following the rotation of the ball screw shaft 31, therefore, the slide guide portion 21 and the head unit 20 move while slightly swaying from side to side with respect to the X-axis in a horizontal plane (X-Y plane) due to the undulation of the sliding surface.

For example, it is assumed that the head unit 20 is moved to a mounting position on the printed board 1 (see Fig. 1), as shown in Fig. 4. In other words, it is assumed that the head unit 20 is parallel moved by a prescribed amount along arrow Y1 due to the undulation of the sliding surface and further rotated slightly counterclockwise by a prescribed horizontal rotation angle from the displaced position. In Fig. 4, the posture of the head unit 20 with sway is illustrated in an exaggerated manner for convenience, and actually, the posture of the head unit 20 is not swayed so much. In Fig. 4, the periphery of the head unit 20 is schematically shown in a state where the surface mounter 100 shown in Fig. 1 is turned upside down in an anteroposterior direction (direction Y) for convenience of description.

According to this embodiment, the following drive control is applied to the head unit 20 in which the centers of the suction nozzles 25 are displaced by the distance L3 beyond the center of the auxiliary camera 24 along arrow Y1 from the center of the main camera 23.

In other words, according to this embodiment, the central processing unit 71 (see Fig. 3) adjusts the numbers of rotations of the servomotors 32 and 42 (see Fig. 3) while taking the previously grasped distortion (undulation) of the guide rail 33 into consideration and performs control of moving the head unit 20. This drive control is performed for each mounting operation on each of the electronic components 2 (see Fig. 2). Thus, a suction nozzle 25 suctioning the electronic component 2 can be accurately moved to a prescribed mounting position of the printed board 1 each time. Operations performed by the central processing unit 71 in order to perform this drive control are hereinafter described in detail.

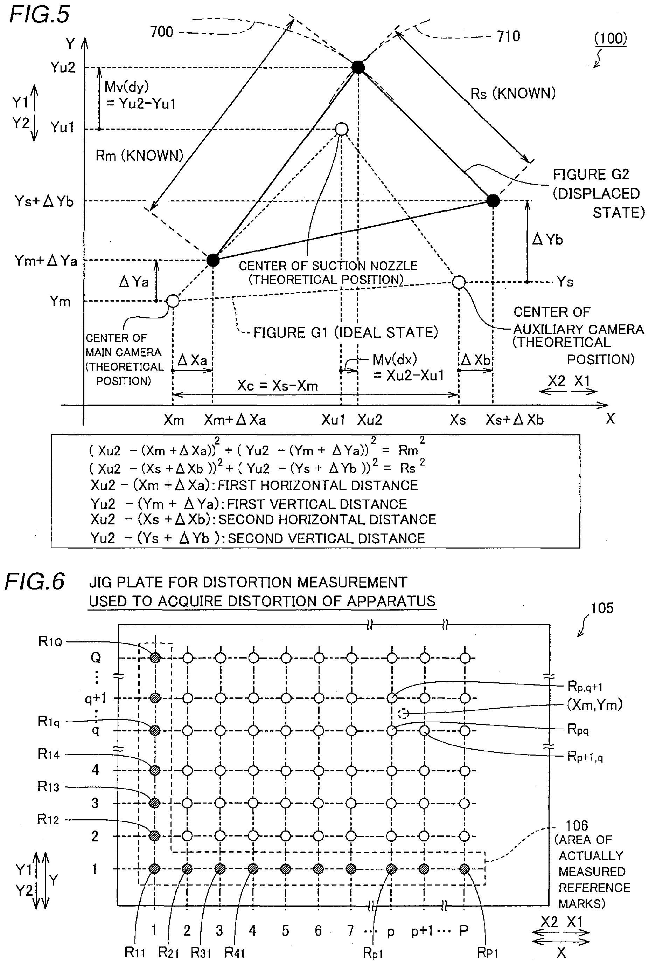

Arithmetic processing performed to mount one electronic component 2 is summarized below. First, the center position of the suction nozzle 25 (actual position coordinates displaced from a theoretical position) is obtained on the basis of the positional relation between the main camera 23, the auxiliary camera 24, and the suction nozzle 25, as shown in Fig. 5. At this time, the center position of the suction nozzle 15 is calculated with the amounts of displacement $\Delta Xa$ and $\Delta Ya$ of the center position of the main camera 23 from the theoretical position coordinates thereof, the amounts of displacement $\Delta Xb$ and $\Delta Yb$ of the center position of the auxiliary camera 24 from the theoretical position coordinates thereof, a distance Rm from the theoretical position coordinates of the center position of the main camera 23 to the theoretical position coordinates of the center position of the suction nozzle 25, and a distance Rs from the theoretical position coordinates of the center position of the auxiliary camera 24 to the theoretical position coordinates of the center position of the suction nozzle 25. Then, the amount of movement Mv(dx) in the direction X of the center position of the suction nozzle 25 and the amount of movement Mv(dy) in the direction Y of the center position of the suction nozzle 25 are calculated by obtaining differences between the theoretical position coordinates of the suction nozzle 25 and the displaced actual position coordinates thereof. Then, the aforementioned calculated amounts of movement Mv(dx) and Mv(dy) are immediately subtracted as correction amounts from the mounting position coordinates of the electronic component 2 specified on a control program, and the amounts of control (numbers of rotations of the servomotors) are obtained while the amounts of displacement of the actual position coordinates of the suction nozzle 25 from the theoretical position coordinates of the suction nozzle 25 are taken into consideration.

The amounts of displacement ΔXa and ΔYa are examples of the "first amount of movement displacement" in the present invention, and the amounts of displacement ΔXb and ΔYb are examples of the "second amount of movement displacement" in the present invention. The amounts of displacement ΔXa and ΔYa are examples of the "first amount of displacement" and the "second amount of displacement" in the present invention, respectively, and the amounts of displacement ΔXb and ΔYb are examples of the "third amount of displacement" and the "fourth amount of displacement" in the present invention, respectively. The amounts of movement Mv(dx) and Mv(dy) are examples of the "first correction amount" and the "second correction amount" in the present invention, respectively. The distances Rm and Rs are examples of the "first radius distance" and the "second radius distance" in the present invention, respectively. A method for obtaining parameters used in the arithmetic processing is hereinafter described.

First, if there is no distortion (undulation) in the guide rail 33 (see Fig. 4) ideally, a straight line 620 (see Fig. 4) passing through the centers of a plurality of suction nozzles 25 in the head unit 20 and the theoretical X-axis line 610 (see Fig. 4) of the mounter are substantially parallel to each other no matter to which position the head unit 20 is moved, as shown in Fig. 5. In this case, the center position coordinates of the main camera 23 that are a theoretical position are represented by (Xm, Ym), and the center position coordinates of the auxiliary camera 24 that are a theoretical position are represented by (Xs, Ys). The center position coordinates of the suction nozzle 25 that are a theoretical position spaced by the distance L3 along arrow Y1 from the main camera 23 are represented by (Xu1, Yu1). In Fig. 5, the posture of the head unit 20 is expressed by a figure G1 (drawn with broken lines) passing through the center points of the main camera 23, the auxiliary camera 24, and the suction nozzle 25.

Next, when the head unit 20 is moved to reach a certain position in a state where the guide rail 33 has distortion (undulation) actually, as shown in Fig. 4, the straight line 620 in the head unit 20 and the X-axis line 610 of the mounter intersect with each other. In other words, the head unit 20 reaches the position of a figure G2 (drawn with solid lines) by moving obliquely parallel along arrow X1 and arrow Y1 from the position of the figure G1 and further rotating counterclockwise in the horizontal plane in Fig. 5. Therefore, the center position coordinates of the suction nozzle 25 are rotationally moved from the theoretical position coordinates (Xu1, Yu1) in the figure G1 to actual position coordinates (Xu2, Yu2) in the figure G2. The actual position coordinates (Xu2, Yu2) are examples of the "intersection coordinates" in the present invention.

There is the following geometric relation between the center positions of the main camera 23, the auxiliary camera 24, and the suction nozzle 25. In other words, when the amounts of displacement ΔXa and ΔYa of the main camera 23 from the theoretical position coordinates thereof are known and a distance between the main camera 23 and the suction nozzle 25 is the distance Rm, the following expression is satisfied in the positional relation between the main camera 23 and the suction nozzle 25 that are displaced:

$$(Xu2 - (Xm + \Delta Xa))^2 + (Yu2 - (Ym + \Delta Ya))^2 = Rm^2 \dots$$

(expression 1)

Similarly, when the amounts of displacement ΔXb and ΔYb of the auxiliary camera 24 from the theoretical position coordinates thereof are known and a distance between the auxiliary camera 24 and the suction nozzle 25 is the distance Rs, the following expression is satisfied in the positional relation between the auxiliary camera 24 and the suction nozzle 25 that are displaced:

$$(Xu2 - (Xs + \Delta Xb))^2 + (Yu2 - (Ys + \Delta Yb))^2 = Rs^2 \dots$$

(expression 2)

In other words, the expression 1 is a circle equation defined with the coordinate position Xu2 in the direction X of the center position of the displaced suction nozzle 25, a first horizontal distance (in the direction X) calculated as "(Xu2 - (Xm + ΔXa)" on the basis of the theoretical position coordinate Xm in the direction X of the main camera 23 and the amount of displacement ΔXa in the direction X of the main camera 23, the coordinate position Yu2 in the direction Y of the center position of the displaced suction nozzle 25, a first vertical distance (in the direction Y) calculated as "(Yu2 - (Ym + ΔYa)" on the basis of the theoretical position coordinate Ym in the direction Y of the main camera 23 and the amount of displacement ΔYa in the direction Y of the main camera 23, and the distance Rm. In Fig. 5, a circle 700 (a part of the circle is shown with a two-dot chain line) having the distance Rm between the center position of the main camera 23 and the center position of the suction nozzle 25 as a radius, employing the center position of the main camera 23 of the actual position coordinates having the amounts of displacement ΔXa and ΔYa as a center is expressed by the expression 1.

The expression 2 is a circle equation defined with the coordinate position Xu2 in the direction X of the center position of the displaced suction nozzle 25, a second horizontal distance (in the direction X) calculated as "(Xu2 - (Xs + ΔXb)" on the basis of the theoretical position coordinate Xs in the direction X of the auxiliary camera 24 and the amount of displacement ΔXb in the direction X of the auxiliary camera 24, the coordinate position Yu2 in the direction Y of the center position of the displaced suction nozzle 25, a second vertical distance (in the direction Y) calculated as "(Yu2 - (Ys + ΔYb)" on the basis of the theoretical position coordinate Ys in the direction Y of the auxiliary camera 24 and the amount of displacement ΔYb in the direction Y of the auxiliary camera 24, and the distance Rs. In Fig. 5, a circle 710 (a part of the circle is shown with a two-dot chain line) having the distance Rs between the center position of the auxiliary camera 24 and the center position of the suction nozzle 25 as a radius, employing the center position of the auxiliary camera 24 of the actual position coordinates having the amounts of displacement ΔXb and ΔYb as a center is expressed by the expression 2. The expressions 1 and 2 are examples of the "first relational expression" and the "second relational expression" in the present invention, respectively.

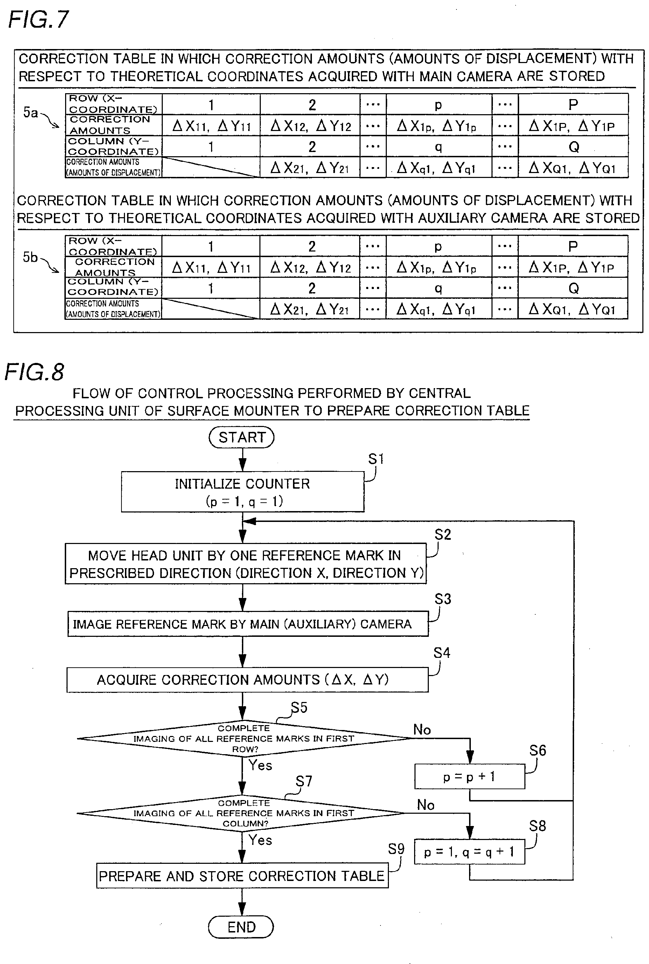

In the expression 1, the amounts of displacement ΔXa and ΔYa of the center position of the main camera 23 from the theoretical position coordinates thereof are values calculated on the basis of a correction table 5a (see Fig. 7) described later, as the amounts of displacement in the direction X and the direction Y of the center position coordinates of the main camera 23 from the figure G1 to the figure G2. In the expression 2, the amounts of displacement ΔXb and ΔYb of the center position of the auxiliary camera 24 from the theoretical position coordinates thereof are values calculated on the basis of a correction table 5b (see Fig. 7) described later, as the amounts of displacement in the direction X and the direction Y of the center position coordinates of the auxiliary camera 24 from the figure G1 to the figure G2. The correction tables 5a and 5b are acquired by experimentally moving the head unit 20 in the mounter before the electronic components 2 (see Fig. 2) are mounted. This point is described later.

Therefore, according to this embodiment, the actual position coordinates (Xu2, Yu2) of the center position of the displaced suction nozzle 25 can be obtained by solving the aforementioned expressions 1 and 2 together. The actual position coordinates (Xu2, Yu2) correspond to the "intersection coordinates" between the circle 700 and the circle 710. Two combinations of solutions (Xu2, Yu2) to a system of equations are obtained, but referring to Fig. 5, a solution (actual position coordinates (Xu2, Yu2)) effective in control processing is specified from the positional relation of Yu2 > Ym + ΔYa and Yu2 > Ys + ΔYb.

The amounts of movement Mv(dx) and Mv(dy) of the center position of the suction nozzle 25 are calculated as correction amounts in control by obtaining the differences between the actual position coordinates (Xu2, Yu2) obtained as a solution to the system of equations and the theoretical position coordinates (Xu1, Yu1) of the suction nozzle 25. In other words,

$$\text{amount of movement Mv(dx) = Xu2 - Xu1 ... (expression 3)}$$

$$\text{amount of movement Mv(dy) = Yu2 - Yu1 ... (expression 4)}$$

Thus, according to this embodiment, the central processing unit 71 calculates the actual position coordinates (Xu2, Yu2) of the displaced suction nozzle 25 on the basis of the positional interrelation between machine coordinates (the theoretical position coordinates (Xm, Ym) of the center position of the main camera 23, the theoretical position coordinates (Xs, Ys) of the center position of the auxiliary camera 24, and the theoretical position coordinates (Xu1, Yu1) of the center position of the suction nozzle 25) constituting the figure G1 through the expressions 1 to 4. The central processing unit 71 estimates the amounts of movement Mv(dx) and Mv(dy) of the center position of the suction nozzle 25 moved to an arbitrary position as in the figure G2 on the basis of the actual position coordinates (Xu2, Yu2). The amounts of movement Mv(dx) and Mv(dy) are examples of the "first correction amount" and the "second correction amount" in the present invention, respectively.

In other words, when a command to mount the electronic component 2 on the coordinates (Xu1, Yu1) of the printed board 1 is performed, even if the head unit 20 and the suction nozzle 25 are moved to these coordinates (theoretical position coordinates) on the control program in a case where this arithmetic processing is not performed, the suction nozzle 25 is actually moved to the actual position coordinates (Xu2, Yu2). When the head unit 20 is moved, therefore, this arithmetic processing is performed to perform control of correcting the number of rotations of the servomotor 32 while taking the amount of movement Mv(dx) in the direction X of the suction nozzle 25 into consideration and control of correcting the number of rotations of the servomotor 42 while taking the amount of movement Mv(dy) in the direction Y of the suction nozzle 25 into consideration. Thus, even if the posture of the head unit 20 in motion sways from side to side due to the distortion of the guide rail 33, the center position of the suction nozzle 25 can be accurately moved toward the theoretical position coordinates (Xu1, Yu1) on the control program.

According to this embodiment, the aforementioned control of correcting the center position (arithmetic processing for calculating the correction amounts by the central processing unit 71) is performed individually with respect to each of the six suction nozzles 25 provided on the head unit 20. Therefore, the electronic component 2 is mounted in a state where the center position of the suction nozzle 25 suctioning the electronic component 2 is corrected even if any of the six suction nozzles 25 is used to mount the electronic component 2.

According to this embodiment, data (correction tables 5a and 5b) to be used as a reference for calculating the amounts of displacement $\Delta Xa$ and $\Delta Ya$ in the directions X and Y of the center position of the main camera 23 expressed in the expression 1 and the amounts of displacement $\Delta Xb$ and $\Delta Yb$ in the directions X and Y of the center position of the auxiliary camera 24 expressed in the expression 2 is previously acquired by the following measurement method. The correction tables 5a and 5b are examples of the "first correction table" and the "second correction table" in the present invention, respectively.

Specifically, the correction amounts (amounts of displacement) serving as reference data for correcting distortion existing in the support portion 30 (X-axis) and the moving mechanism 40 (Y-axis) of the surface mounter 100 are measured with a jig plate 105 made of glass, shown in Fig. 6. On a surface of this jig plate 105, a plurality of (P × Q) reference marks R ($R_{11}$ to $R_{PQ}$) are printed in a lattice pattern along directions (X-axis and Y-axis directions) orthogonal to each other. In place of the printed board 1, the jig plate 105 is placed on the conveyor portions 11 and is fixed to a prescribed position. Thereafter, the head unit 20 is moved, and the individual reference marks R are successively imaged.

According to this embodiment, the main camera 23 (see Fig. 4) of the head unit 20 is first used to image the individual reference marks R, and the amounts of displacement of the reference marks R imaged at respective positions from the theoretical positions are obtained. By way of example, the support portion 30 (X-axis) and the moving mechanism 40 (Y-axis) are driven to move the center of the main camera 23 to the coordinates (1, 1) on the control program, for example. In this case, if the center position coordinates (1, 1) in the imaging field of view of the main camera 23 and a reference mark $R_{11}$ applied to actual coordinates ($X_{11}$, $Y_{11}$) in the jig plate 105 do not completely overlap with each other, the correction amounts (amounts of displacement) of the actual coordinates ($X_{11}$, $Y_{11}$) with respect to the theoretical coordinates (1, 1) are obtained as ($\Delta X_{11}$, $\Delta Y_{11}$) on the basis of an image processing result after imaging. This calculation of the correction amounts is sequentially performed from the reference mark $R_{11}$ (actual coordinates ($X_{11}$, $Y_{11}$)) to a reference mark $R_{P1}$ (actual coordinates ($X_{1P}$, $Y_{1P}$)) along the guide rail 33 by driving the support portion 30 in the direction X. After the center position of the main camera 23 is returned to the reference point (original point), the calculation of the correction amounts is sequentially performed from a reference mark $R_{12}$ (actual coordinates ($X_{21}$, $Y_{21}$)) to a reference mark $R_{1Q}$ (actual coordinates ($X_{Q1}$, $Y_{Q1}$)) along the guide rail 43 by driving the moving mechanism 40 in the direction Y while fixing the support portion 30. In other words, the correction amounts ($\Delta X$, $\Delta Y$) are calculated with respect to each of reference marks R existing in an L-shaped area 106 surrounded by a broken line in Fig. 6. Consequently, the correction table 5a shown in an upper region of Fig. 7 is obtained.

Through a procedure similar to the above, the correction amounts ($\Delta X$, $\Delta Y$) with respect to the auxiliary camera 24 (see Fig. 4) are calculated. In this case, the jig plate 105 temporarily fixed to the conveyor portions 11 is moved by a center-to-center distance Xc (= |Xs - Xm|) (see Fig. 5) between the main camera 23 and the auxiliary camera 24 along arrow X1 and is refixed to the conveyor portions 11, whereby the jig plate 105 is set to a position for the auxiliary camera 24. Then, the correction amounts ($\Delta X$, $\Delta Y$) are calculated with respect to each of the reference marks $R_{11}$ to $R_{P1}$ and the reference marks $R_{12}$ to $R_{1Q}$ while the reference marks $R_{11}$ to $R_{P1}$ aligned in the direction X and the reference marks $R_{12}$ to $R_{1Q}$ aligned in the direction Y are successively imaged with the auxiliary camera 24. Consequently, the correction table 5b shown in a lower region of Fig. 7 is obtained. The correction tables 5a and 5b are stored in the correction data storage portion 72b (see Fig. 3) of the storage portion 72. In this manner, basic data to obtain the aforementioned amounts of displacement $\Delta Xa$ and $\Delta Ya$ in the directions X and Y of the main camera 23 and the aforementioned amounts of displacement $\Delta Xb$ and $\Delta Yb$ in the directions X and Y of the auxiliary camera 24 is previously acquired.

Therefore, by way of example, when the electronic component 2 is mounted on the coordinates (Xu1, Yu1) of the printed board 1, the central processing unit 71 extracts the correction amounts ($\Delta X$, $\Delta Y$) corresponding to a reference mark $R_{pq}$ nearest to the center position coordinates (Xm, Ym) of the main camera 23 while referring to the correction table 5a and extracts the correction amounts ($\Delta X$, $\Delta Y$) of the auxiliary camera 24 separated by the distance Xc from the main camera 23 while referring to the correction table 5b. As to the correction amounts ($\Delta X$, $\Delta Y$), only data regarding the reference marks R in the L-shaped area 106 surrounded by a broken line in Fig. 6 is stored in the correction table 5a (5b), as described above. Thus, according to this embodiment, an X-component $\Delta X_{1p}$ of the correction amount of a reference mark $R_{p1}$ and a Y-component $\Delta Y_{q1}$ of the correction amount of a reference mark $R_{1q}$ are used for the correction amounts ($\Delta X$, $\Delta Y$) with respect to the reference mark $R_{pq}$ nearest to the center position coordinates (Xm, Ym) or (Xs, Ys). In other words, the processing is performed by substituting the components ($\Delta X_{1p}$, $\Delta Y_{q1}$) for the correction amounts

($\Delta$X, $\Delta$Y) with respect to the reference mark $R_{pq}$. This is because the amounts of displacement of the main camera 23 (or the auxiliary camera 24) due to the distortion of the guide rail 33 constituting the X-axis are the same no matter to which position on the guide rail 43 the moving mechanism 40 responsible for Y-axis movement is fixed, so that it is not necessary to measure the correction amounts (amounts of displacement) with respect to all the reference marks R (P $\times$ Q in total) in the jig plate 105. Thus, the capacity of the correction data storage portion 72b is also saved.

When the correction amounts ($\Delta X_{1p}$, $\Delta Y_{q1}$) corresponding to the reference mark $R_{pq}$ nearest to the center position coordinates (Xm, Ym) of the main camera 23 (see Fig. 4) are extracted by the aforementioned method, the coordinates of this reference mark $R_{pq}$ and the coordinates (Xm, Ym) of the main camera 23 do not strictly coincide with each other. Therefore, the strict correction amounts ($\Delta$X, $\Delta$Y) corresponding to the coordinates (Xm, Ym) are calculated by interpolating the respective correction amounts corresponding to a reference mark $R_{(p+1, q)}$ next to the nearest reference mark $R_{pq}$ in the direction X and a reference mark $R_{(p, q+1)}$ next to the nearest reference mark $R_{pq}$ in the direction Y, as shown in Fig. 6.

According to this embodiment, the central processing unit 71 refers to the correction tables 5a and 5b in the arithmetic processing to acquire the amounts of displacement $\Delta$Xa and $\Delta$Ya of the center position of the main camera 23 from the theoretical position coordinates and the amounts of displacement $\Delta$Xb and $\Delta$Yb of the center position of the auxiliary camera 24 from the theoretical position coordinates, respectively. Furthermore, the central processing unit 71 solves the expressions 1 and 2 together to obtain the actual position coordinates (Xu2, Yu2) of the displaced suction nozzle 25. In addition, the central processing unit 71 calculates the final amount of movement Mv(dx) and the final amount of movement Mv(dy) expressed by the expressions 3 and 4, respectively. The servomotor 32 (see Fig. 3) is immediately rotated while this arithmetic processing and the amount of movement Mv(dx) in the direction X of the suction nozzle 25 are taken into consideration, and the servomotor 42 (see Fig. 3) is rotated while this arithmetic processing and the amount of movement Mv(dy) in the direction Y of the suction nozzle 25 are taken into consideration. Thus, the suction nozzle 25 is accurately moved toward the coordinates (Xu1, Yu1) on the control program without displacement.

Each of the suction nozzles 25 is configured to be movable in the vertical direction (direction Z) with respect to the head unit 20 by a servomotor 26 (see Fig. 3) and an unshown elevating mechanism. In the surface mounter 100, the suction nozzles 25 suction the electronic components 2 (see Fig. 2) from the tape feeders 3 (see Fig. 1) in a state where the same are lowered to move-down positions by the head unit 20, are returned to move-up positions in a state where the same suction the electronic components 2, are conveyed to prescribed positions on the printed board 1 (see Fig. 1), are lowered again at the prescribed positions, and mount the electronic components 2 on the printed board 1. Furthermore, each of the suction nozzles 25 is configured to be rotated in the X-Y plane about a nozzle axis (Z-axis) by a servomotor 27 (see Fig. 3) and an unshown rotating mechanism. Thus, the postures (orientations in the X-Y plane) of the electronic components 2 held by forward end portions of the suction nozzles 25 are finely adjusted.

On the upper surface 4a of the base 4, a board camera 50 and a component camera 60 are fixedly set. The component camera 60 has a function of imaging the lower surface sides of the electronic components 2 suctioned by the suction nozzles 25 from below. Thus, whether the shapes of the electronic components 2 are good or not is determined, and whether the suction positions of the suction nozzles 25 with respect to the electronic components 2 are good or not is determined.

As shown in Fig. 3, the operation of the surface mounter 100 is controlled by the controller 70. The central processing unit 71 generally controls the operation of the surface mounter 100. Control programs capable of being executed by the central processing unit 71, data required to move the head unit 20, etc. are stored in the operating program storage portion 72a of the storage portion 72. Furthermore, the aforementioned correction tables 5a and 5b are stored in the correction data storage portion 72b. The image processing portion 73 has a function of internally generating data required for the operation of the surface mounter 100 by processing image data imaged by the main camera 23 and the auxiliary camera 24 in addition to the board camera 50.

The motor control portion 74 is configured to control the servomotors (the servomotor 42 (see Fig. 1) moving the support portion 30 in the direction Y, the servomotor 32 (see Fig. 1) moving the head unit 20 in the direction X, the servomotor 26 moving the suction nozzles 25 in the vertical direction, the servomotor 27 rotating the suction nozzles 25 about the nozzle axes, etc.) of the surface mounter 100 on the basis of control signals output from the central processing unit 71. Furthermore, the motor control portion 74 is configured to control a servomotor of a board conveyance axis (not shown) provided in the board conveying portion 10. In addition, the motor control portion 74 is configured to be capable of recognizing the position of the head unit 20 in the X-Y plane, the height positions and rotation positions of the suction nozzles 25, etc. on the basis of signals from encoders (not shown) of the servomotors. The external input/output portion 75 has a function of controlling input/output from various operating buttons 76 including an operation start button and various sensors 77 such as the board sensors. In this manner, the surface mounter 100 is configured.

Next, the flow of control processing performed by the central processing unit 71 to acquire the correction amounts (amounts of displacement) serving as reference data for correcting the distortion of the surface mounter 100 with the main camera 23 and the auxiliary camera 24 is described with reference to Figs. 1, 3, and 5 to 8. Before this flow of control processing is started, the user places the jig plate 105 on the conveyor portions 11 (see Fig. 1) and fixes the jig plate 105 to the prescribed position. Therefore, the operation of the surface mounter 100 (see Fig. 1) after fixing of the jig plate 105 (see Fig. 6) to the conveyor portions 11 is described below. As a typical example, the operation of the surface mounter 100 for obtaining the correction amounts (amounts of displacement) with the main camera 23 (see Fig. 1) is described.

At a step S1, the central processing unit 71 (see Fig. 3) initializes a variable (counter) for counting the number of times of imaging by the main camera 23 (see Fig. 3), as shown in Fig. 8. In other words, the counter is set to p = 1 and q = 1. At a step S2, on the basis of a command of the central processing unit 71, the servomotor 32 (see Fig, 3) is driven to move the center position (center point of the imaging field of view) of the main camera 23 of the head unit 20 (see Fig. 1) to the theoretical coordinates (1, 1) on the control program. At a step S3, the main camera 23 images the reference mark $R_{11}$ applied to the actual coordinates $(X_{11}, Y_{11})$ in a first row on the jig plate 105 (see Fig. 6) fixed to the conveyor portions 11 (see Fig. 1) while the center of the main camera 23 stops at the theoretical coordinates (1, 1).

At a step S4, the central processing unit 71 calculates the correction amounts (amounts of displacement) of the actual coordinates $(X_{11}, Y_{11})$ with respect to the theoretical coordinates (1, 1) as $(\Delta X_{11}, \Delta Y_{11})$ on the basis of the image processing result after imaging by the main camera 23.

At a step S5, the central processing unit 71 determines whether or not imaging of all the reference marks R $(R_{11}$ to $R_{P1})$ in the first row (in the direction X) is completed. If determining that imaging of all the reference marks R $(R_{11}$ to $R_{P1})$ in the first row is not completed at the step S5 ("no" determination), the central processing unit 71 increments p by one (p = p + 1) at a step S6. Then, the central processing unit 71 returns to the step S2, and repeats the same processing described above. In other words, at the steps S2 to S6, the center position of the main camera 23 is transversely moved from the theoretical coordinates (1, 1) to coordinates (2, 1), a reference mark $R_{21}$ (see Fig. 6) of a corresponding actual coordinates $(X_{12}, Y_{12})$ in the first row is imaged, and the correction amounts $(\Delta X_{12}, \Delta Y_{12})$ are calculated on the basis of the image processing. Thereafter, p is incremented by one, the center of the main camera 23 is transversely moved from the theoretical coordinates (2, 1) to coordinates (3, 1), a reference mark $R_{31}$ (see Fig. 6) of a corresponding actual coordinates $(X_{13}, Y_{13})$ in the first row is imaged, and the correction amounts $(\Delta X_{13}, \Delta Y_{13})$ are calculated on the basis of the image processing. These operations are repeated until p = P. The calculated correction amounts $(\Delta X, \Delta Y)$ corresponding to actual coordinates in the first row are temporarily stored in a working memory area of the storage portion 72 (see Fig. 3) each time.

If determining that imaging of all the reference marks R $(R_{11}$ to $R_{P1})$ in the first row (in the direction X) is completed at the step S5 ("yes" determination), the central processing unit 71 determines whether or not imaging of all the reference marks R $(R_{12}$ to $R_{1Q})$ in a first column (in the direction Y) is completed at a step S7. If determining that imaging of all the reference marks R $(R_{12}$ to $R_{1Q})$ in the first column is not completed at the step S7 ("no" determination), the central processing unit 71 sets p = 1 as a fixed value and increments q by one (q = q + 1) at a step S8. Then, the central processing unit 71 returns to the step S2, and repeats the same processing described above. In other words, at the steps S2 to S8 (except the step S6), the center position of the main camera 23 is moved from a theoretical coordinates (P, 1) to coordinates (1, 2), the reference mark $R_{12}$ (see Fig. 6) of the corresponding actual coordinates $(X_{21}, Y_{21})$ in the first column is imaged, and the correction amounts $(\Delta X_{21}, \Delta Y_{21})$ are calculated on the basis of the image processing. Thereafter, q is incremented by one, the center of the main camera 23 is moved from the theoretical coordinates (1, 2) to coordinates (1, 3), a reference mark $R_{13}$ (see Fig. 6) of a corresponding actual coordinates $(X_{31}, Y_{31})$ in the first column is imaged, and the correction amounts $(\Delta X_{31}, \Delta Y_{31})$ are calculated on the basis of the image processing. These operations are repeated until q = Q (p = 1 is a fixed value). The calculated correction amounts $(\Delta X, \Delta Y)$ corresponding to actual coordinates in the first column are temporarily stored in the working memory area of the storage portion 72 each time.

If determining that imaging of all the reference marks R $(R_{12}$ to $R_{1Q})$ in the first column (in the direction Y) is completed at the step S7 ("yes" determination), the central processing unit 71 prepares the correction table 5a (see Fig. 7) while referring to the correction amounts $(\Delta X, \Delta Y)$ corresponding to the actual coordinates stored in the working memory area of the storage portion 72, and stores the correction table 5a in the correction data storage portion 72b (see Fig. 3) at a step S9. In this manner, the central processing unit 71 acquires the respective correction amounts $(\Delta X, \Delta Y)$ regarding the reference marks R in the L-shaped area 106 surrounded by a broken line in Fig. 6, and terminates this control processing.

The aforementioned flow of this control processing is also applied to the operation of the auxiliary camera 24 (see Fig. 3) for obtaining the correction amounts (amounts of displacement), similarly. In this case, the user moves the jig plate 105 (see Fig. 6) temporarily fixed to the conveyor portions 11 (see Fig. 1) by the center-to-center distance Xc (= |Xs - Xm|) (see Fig. 5) between the main camera 23 and the auxiliary camera 24 along arrow X1 and refixes the jig plate 105 to the conveyor portions 11 thereby setting the jig plate 105 to the position for the auxiliary camera 24. Then, the flow of this control processing is performed, and the correction table 5b (see Fig. 7) is prepared and is stored in the correction data storage portion 72b (see Fig. 3). In this manner, basic data of the correction amounts (amounts of displacement) for correcting the distortion of the surface mounter 100 is acquired with the main camera 23 and the auxiliary camera 24.

Next, the flow of control processing performed by the central processing unit 71 to mount the electronic components 2 on the printed board 1 is described with reference to Figs. 2, 3, 5 to 7, and 9.

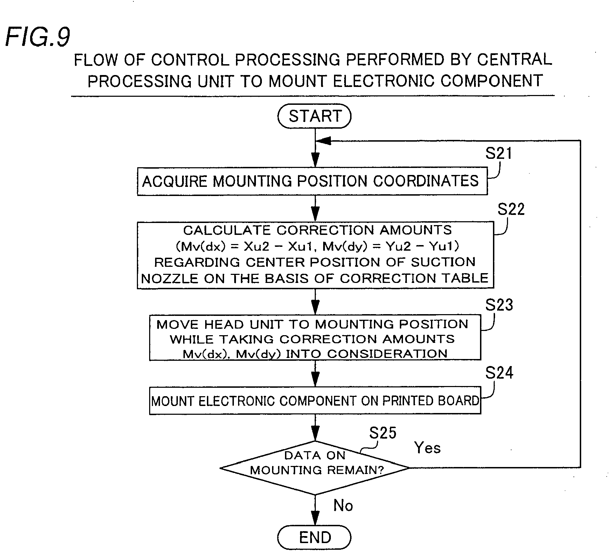

At a step S21, the central processing unit 71 (see Fig. 3) reads the mounting position coordinates ((Xu1, Yu1), for example (see Fig. 5)) of a first electronic component 2 (see Fig. 2) included in data on component mounting, as shown in Fig. 9.

At a step S22, the central processing unit 71 calculates the correction amounts (amounts of movement Mv(dx) and Mv(dy)) for moving the head unit 20 on the basis of the correction tables 5a and 5b (see Fig. 7).

Specifically, the central processing unit 71 extracts the correction amounts $(\Delta X_{1p}, \Delta Y_{q1})$ calculated with respect to the reference mark $R_{pq}$ (see Fig. 6) nearest to the center position coordinates (Xm, Ym) of the main camera 23 from the correction table 5a, and extracts the correction amounts $(\Delta X_{1, p+1}, \Delta Y_{q1})$ corresponding to the reference mark $R_{(p+1, q)}$ next to the nearest reference mark $R_{pq}$ along arrow X1 and the correction amounts $(\Delta X_{1p}, \Delta Y_{q+1, 1})$ corresponding to the reference mark $R_{(p, q+1)}$ next to the nearest reference mark $R_{pq}$ along arrow Y1. Then, the central processing unit 71 calculates the correction amount $\Delta Xa$ corresponding to the X-coordinate Xm and the correction amount $\Delta Ya$ corresponding to the Y-coordinate Ym by interpolating the correction amounts. Similarly, the central processing unit 71 extracts the correction amounts $(\Delta X_{1p}, \Delta Y_{q1})$ calculated with respect to the reference mark $R_{pq}$ (see Fig. 6) nearest to the center position coordinates (Xs, Ys) of the auxiliary camera 24 from the correction table 5b, and extracts the correction amounts $(\Delta X_{1, p+1}, \Delta Y_{q1})$ corresponding to the reference mark $R_{(p+1, q)}$ next to the nearest reference mark $R_{pq}$ along arrow X1 and the correction amounts $(\Delta X_{1p}, \Delta Y_{q+1, 1})$ corresponding to the reference mark $R_{(p, q+1)}$ next to the nearest reference mark $R_{pq}$ along arrow Y1. Then, the central processing unit 71 calculates the correction amount $\Delta Xb$ corresponding to the X-coordinate Xs and the correction amount $\Delta Yb$ corresponding to the Y-coordinate Ys by interpolating the correction amounts.

Then, the central processing unit 71 substitutes data of the theoretical position coordinates (Xm, Ym) of the center position of the main camera 23, the theoretical position coordinates (Xs, Ys) of the center position of the auxiliary camera 24, the distance Rm between the main camera 23 and the suction nozzle 25, the distance Rs between the auxiliary camera 24 and the suction nozzle 25, the aforementioned correction amounts $(\Delta Xa, \Delta Ya)$ calculated with respect to the main camera 23, and the aforementioned correction amounts $(\Delta Xb, \Delta Yb)$ calculated with respect to the auxiliary camera 24 into the expressions 1 and 2, and solves the expressions 1 and 2 together to obtain Xu2 and Yu2. Then, the central processing unit 71 calculates the final correction amount (amount of movement Mv(dx) (= Xu2 - Xu1)) on the basis of the expression 3 and calculates the final correction amount (amount of movement Mv(dy) (= Yu2 - Yu1)) on the basis of the expression 4. At the step S22, the central processing unit 71 performs this arithmetic processing.

At a step S23, the central processing unit 71 moves the head unit 20 to the mounting position while taking the correction amounts (amounts of movement Mv(dx) and Mv(dy)) obtained at the step S22 into consideration. In other words, the central processing unit 71 rotates the servomotor 32 (see Fig. 3) while taking the amount of movement Mv(dx) in the direction X of the suction nozzle 25 into consideration and rotates the servomotor 42 (see Fig. 3) while taking the amount of movement Mv(dy) in the direction Y of the suction nozzle 25 into consideration. At a step S24, the central processing unit 71 mounts the electronic component 2 (see Fig. 2) on the printed board 1 (see Fig. 2) in the head unit 20 in the state moved to the mounting position.

At a step S25, the central processing unit 71 determines whether or not unimplemented data on component mounting remains. If determining that the data on component mounting remains at the step S25 ("yes" determination), the central processing unit 71 returns to the step S21, and repeats the same processing described above. In other words, the central processing unit 71 reads the mounting position coordinates (Xu1, Yu1) of an electronic component 2 to be newly mounted, and calculates the correction amounts (amounts of movement Mv(dx) and Mv(dy)) regarding this electronic component 2 on the basis of the correction tables 5a and 5b (see Fig. 7). Then, the central processing unit 71 rotates the servomotor 32 (see Fig. 3) while taking the amount of movement Mv(dx) in the direction X of the suction nozzle 25 into consideration and rotates the servomotor 42 (see Fig. 3) while taking the amount of movement Mv(dy) in the direction Y of the suction nozzle 25 into consideration, and mounting of the electronic component 2 on the printed board 1 is repeated for each mounting operation. If determining that there is no unimplemented data on component mounting (mounting of all the electronic components 2 is completed) at the step S25 ("no" determination), the central processing unit 71 terminates this control processing.

According to this embodiment, as hereinabove described, the central processing unit 71 is configured to perform control of correcting the actual position coordinates (Xu2, Yu2) of the suction nozzle 25 on the basis of the amounts of displacement $\Delta Xa$ (in the direction X) and $\Delta Ya$ (in the direction Y) of the actual position coordinates of the center position of the main camera 23 with respect to the theoretical position coordinates of the center position of the main camera 23, the amounts of displacement $\Delta Xb$ (in the direction X) and $\Delta Yb$ (in the direction Y) of the actual position coordinates of the center position of the auxiliary camera 24 with respect to the theoretical position coordinates of the center position of the auxiliary camera 24, and the positional interrelation between the main camera 23, the auxiliary camera 24, and the suction nozzle 25 when moving the head unit 20. Thus, the central processing unit 71 can properly correct the center position of the suction nozzle 25 and move the head unit 20 in the X-Y plane on the basis of the amounts of displacement ΔXa and ΔYa, the amounts of displacement ΔXb and ΔYb, and the positional interrelation between the main camera 23, the auxiliary camera 24, and the suction nozzle 25 when moving the head unit 20 even if the head unit 20 in which the suction nozzles 25 are not arranged on the straight line 500 passing through the center of the main camera 23 and the center of the auxiliary camera 24 (the suction nozzles 25 are spaced by the distance L3 along arrow Y1 from the main camera 23) is used. Thus, the central processing unit 71 can accurately move the suction nozzle 25 to the mounting position on the printed board 1.

According to this embodiment, the auxiliary camera 24 is arranged at a different position along arrow Y1 with respect to the main camera 23 in the head unit 20. When this head unit 20 in which the auxiliary camera 24 is arranged at the different position in the direction Y with respect to the main camera 23 is moved, the center position of the suction nozzle 25 can be properly corrected on the basis of the amounts of displacement ΔXa and ΔYa, the amounts of displacement ΔXb and ΔYb, and the positional interrelation between the main camera 23, the auxiliary camera 24, and the suction nozzle 25.

According to this embodiment, the intersection coordinates (Xu2, Yu2) at which the circle 700 (see Fig. 5) having the distance Rm between the center position of the main camera 23 and the center position of the suction nozzle 25 as a radius, employing the center position of the main camera 23 of the actual position coordinates having the amounts of displacement ΔXa and ΔYa as a center and the circle 710 (see Fig. 5) having the distance Rs between the center position of the auxiliary camera 24 and the center position of the suction nozzle 25 as a radius, employing the center position of the auxiliary camera 24 of the actual position coordinates having the amounts of displacement ΔXb and ΔYb as a center intersect with each other are the center position (actual position coordinates) of the suction nozzle 25 obtained on the basis of the positional interrelation between the main camera 23, the auxiliary camera 24, and the suction nozzle 25. Furthermore, the central processing unit 71 is configured to perform control of correcting the center position of the suction nozzle 25 on the basis of the correction amount (amount of movement Mv(dx)) that is the difference in the direction X between the theoretical position coordinates (Xu1, Yu1) of the center position of the suction nozzle 25 and the actual position coordinates (Xu2, Yu2) thereof and the correction amount (amount of movement Mv(dy)) that is the difference in the direction Y between the theoretical position coordinates (Xu1, Yu1) of the center position of the suction nozzle 25 and the actual position coordinates (Xu2, Yu2) thereof. Thus, the central processing unit 71 can easily specify (estimate) the actual position coordinates (intersection coordinates) of the center position of the displaced suction nozzle 25 on the basis of the positional interrelation between the main camera 23, the auxiliary camera 24, and the suction nozzle 25, and hence the central processing unit 71 can easily obtain the amounts of movement Mv(dx) and Mv(dy) corresponding to the differences between the displaced actual position coordinates and the theoretical position coordinates. Thus, the central processing unit 71 can accurately move the suction nozzle 25 to the mounting position on the printed board 1 while taking the amounts of movement Mv(dx) and Mv(dy) into consideration as the correction amounts.

According to this embodiment, the central processing unit 71 is configured to perform control of moving the center position of the suction nozzle 25 to position coordinates obtained by subtracting the amount of movement Mv(dx) in the direction X and the amount of movement Mv(dy) in the direction Y from the theoretical position coordinates of the center position of the suction nozzle 25, respectively when moving the head unit 20. Thus, the center position of the suction nozzle 25 can be easily corrected with the amount of movement Mv(dx) and the amount of movement Mv(dy) in the arithmetic processing performed by the central processing unit 71, and hence the suction nozzle 25 of the head unit 20 can be easily moved to a working position after correction.

According to this embodiment, the intersection coordinates (Xu2, Yu2) as the center position of the suction nozzle 25 are calculated on the basis of the expression 1 as the first relational expression satisfied between the actual position coordinates (intersection coordinates (Xu2, Yu2)), the theoretical position coordinates (Xm, Ym) of the main camera 23, the amount of displacement ΔXa, the amount of displacement ΔYa, and the distance Rm and the expression 2 as the second relational expression satisfied between the intersection coordinates (Xu2, Yu2), the theoretical position coordinates (Xs, Ys) of the auxiliary camera 24, the amount of displacement ΔXb, the amount of displacement ΔYb, and the distance Rs. Thus, the actual position coordinates (intersection coordinates) of the center position of the suction nozzle 25 in the horizontal plane (X-Y plane) can be easily calculated utilizing numerical calculation or the like. Therefore, the correction amounts (amounts of movement Mv(dx) and Mv(dy)) corresponding to the differences between the actual position coordinates (intersection coordinates) and the theoretical position coordinates used in the control of correcting the center position of the suction nozzle 25 can be accurately obtained.

According to this embodiment, the expression 1 is the equation of the circle 700 defined with the coordinate position Xu2 in the direction X of the center position of the displaced suction nozzle 25, the first horizontal distance (= Xu2 - (Xm + ΔXa)) in the direction X calculated on the basis of the theoretical position coordinate Xm in the direction X of the main camera 23 and the amount of displacement ΔXa in the direction X of the main camera 23, the coordinate position Yu2 in the direction Y of the center position of the displaced suction nozzle 25, the first vertical distance (= Yu2 - (Ym + ΔYa)) in the direction Y calculated on the basis of the theoretical position coordinate Ym in the direction Y of the main camera 23 and the amount of displacement ΔYa in the direction Y of the main camera 23, and the distance Rm. Furthermore, the expression 2 is the equation of the circle 710 defined with the coordinate position Xu2 in the direction X of the center position of the displaced suction nozzle 25, the second horizontal distance (= Xu2 - (Xs + $\Delta$Xb)) in the direction X calculated on the basis of the theoretical position coordinate Xs in the direction X of the auxiliary camera 24 and the amount of displacement $\Delta$Xb in the direction X of the auxiliary camera 24, the coordinate position Yu2 in the direction Y of the center position of the displaced suction nozzle 25, the second vertical distance (= Yu2 - (Ys + $\Delta$Yb)) in the direction Y calculated on the basis of the theoretical position coordinate Ys in the direction Y of the auxiliary camera 24 and the amount of displacement $\Delta$Yb in the direction Y of the auxiliary camera 24, and the distance Rs. Thus, the expressions 1 and 2 defined as circle equations are solved together, whereby the center position (intersection coordinates (Xu2, Yu2)) of the suction nozzle 25 corresponding to a point at which the two circles 700 and 710 intersect with each other can be easily obtained.

According to this embodiment, the intersection coordinates (Xu2, Yu2) are calculated by solving the expressions 1 and 2 defined as the equations of the circles 700 and 710, respectively, together, and one set of the intersection coordinates (Xu2, Yu2) effective in the control processing for correcting the center position of the suction nozzle 25 is selected from two sets of the intersection coordinates obtained by solving the expressions 1 and 2 together on the basis of the positional interrelation between the main camera 23, the auxiliary camera 24, and the suction nozzle 25. Thus, a solution (intersection coordinates) ineffective in the control processing for correcting the center position of the suction nozzle 25 can be easily eliminated, and hence the center position (intersection coordinates (Xu2, Yu2)) of the suction nozzle 25 effective in the control processing can be accurately acquired.

According to this embodiment, the central processing unit 71 is configured to perform control of correcting the center position of the suction nozzle 25 and moving the head unit 20 on the basis of the amounts of displacement $\Delta$Xa and $\Delta$Ya, the amounts of displacement $\Delta$Xb and $\Delta$Yb, and the positional interrelation between the main camera 23, the auxiliary camera 24, and the suction nozzle 25 when a component mounting operation for mounting the electronic component 2 on the printed board 1 is performed with the head unit. Thus, it is only necessary for the central processing unit 71 to calculate the amounts of movement Mv(dx) and Mv(dy) serving as the correction amounts of the center position of the suction nozzle 25 each time the component mounting operation is performed. In other words, as compared with a case where correction amounts (amounts of movement Mv(dx) and Mv(dy)) regarding a large number of mounting positions are obtained in a matrix manner to cover an entire region in the X-Y plane and are stored as data in the surface mounter 100, for example, it is not necessary to hold a large amount of data, so that the amount of data held in the surface mounter 100 can be significantly reduced.

According to this embodiment, the central processing unit 71 is configured to perform control of correcting the center position of the suction nozzle 25 and moving the head unit 20 on the basis of the amounts of displacement $\Delta$Xa and $\Delta$Ya, the amounts of displacement $\Delta$Xb and $\Delta$Yb, and the positional interrelation between the main camera 23, the auxiliary camera 24, and the suction nozzle 25 each time a single mounting operation on each of the electronic components 2 is performed. Thus, the control of correcting the center position of the suction nozzle 25 and moving the head unit 20 is performed once in every operation for mounting the individual electronic components 2, and hence the suction nozzle 25 can be accurately moved to the corresponding mounting position each time a mounting operation is performed on each of the electronic components 2 at a different mounting position.

According to this embodiment, the central processing unit 71 is configured to perform the arithmetic processing for correcting the center position of the suction nozzle 25 and perform control of moving the head unit 20 on the basis of the amounts of displacement $\Delta$Xa and $\Delta$Ya, the amounts of displacement $\Delta$Xb and $\Delta$Yb, and the positional interrelation between the main camera 23, the auxiliary camera 24, and the suction nozzle 25. Thus, the head unit 20 can be moved actually while the arithmetic processing for correcting the center position of the suction nozzle 25 is performed, and hence the takt time required for a mounting operation on each of the electronic components 2 can be inhibited from increasing due to the arithmetic processing.

According to this embodiment, the surface mounter 100 includes the correction tables 5a and 5b to which the central processing unit 71 refers for the amounts of displacement ($\Delta$Xa, $\Delta$Ya, $\Delta$Xb, $\Delta$Yb) of the respective actual position coordinates with respect to the respective theoretical position coordinates of the center of the main camera 23 and the center of the auxiliary camera 24 when moving the head unit 20 in the X-Y plane. Furthermore, the central processing unit 71 is configured to perform control of correcting the center position of the suction nozzle 25 on the basis of the amounts of displacement $\Delta$Xa and $\Delta$Ya regarding the center position of the main camera 23 grasped on the basis of the correction table 5a, the amounts of displacement $\Delta$Xb and $\Delta$Yb regarding the center position of the auxiliary camera 24 grasped on the basis of the correction table 5b, and the positional interrelation between the main camera 23, the auxiliary camera 24, and the suction nozzle 25 when moving the head unit 20. Thus, the arithmetic processing for correcting the center position of the suction nozzle 25 can be promptly performed on the basis of the amounts of displacement $\Delta$Xa, $\Delta$Ya, the amounts of displacement $\Delta$Xb and $\Delta$Yb, and the positional interrelation between the main camera 23, the auxiliary camera 24, and the suction nozzle 25, effectively utilizing the correction tables 5a and 5b.

According to this embodiment, the correction table 5a in which the amounts of displacement $\Delta$Xa and $\Delta$Ya of the actual position coordinates with respect to the theoretical position coordinates of the center of the main camera 23 are defined and the correction table 5b in which the amounts of displacement $\Delta$Xb and $\Delta$Yb of the actual position coordinates with respect to the theoretical position coordinates of the center of the auxiliary camera 24 are defined are stored in the correction data storage portion 72b. Furthermore, the central processing unit 71 is configured to perform control of correcting the center position of the suction nozzle 25 on the basis of the amounts of displacement $\Delta$Xa and $\Delta$Ya regarding the center position of the main camera 23 calculated with the correction table 5a, the amounts of displacement $\Delta$Xb and $\Delta$Yb regarding the center position of the auxiliary camera 24 calculated with the correction table 5b, and the positional interrelation between the main camera 23, the auxiliary camera 24, and the suction nozzle 25 when moving the head unit 20. Thus, the amounts of displacement $\Delta$Xa and $\Delta$Ya can be easily calculated with the correction table 5a, and the amounts of displacement $\Delta$Xb and $\Delta$Yb can be easily calculated with the correction table 5b.

According to this embodiment, the surface mounter 100 includes the support portion 30 so configured that the head unit 20 is movable in the X-Y plane, and the support portion 30 has the guide rail 33 extending in the direction X to move the head unit 20 along the direction X. Furthermore, the central processing unit 71 is configured to perform control of correcting the center position of the suction nozzle 25 on the basis of the amounts of displacement $\Delta$Xa and $\Delta$Ya regarding the center position of the main camera 23 resulting from the distortion of the guide rail 33, the amounts of displacement $\Delta$Xb and $\Delta$Yb regarding the center position of the auxiliary camera 24 resulting from the distortion of the guide rail 33, and the positional interrelation between the main camera 23, the auxiliary camera 24, and the suction nozzle 25 when moving the head unit 20 in the direction X by the support portion 30. Thus, even if the guide rail 33 of the support portion 30 extending in the direction X is deformed such as undulated in the direction Y, the center position of the suction nozzle 25 can be properly corrected on the basis of the amounts of displacement $\Delta$Xa, $\Delta$Ya, $\Delta$Xb, and $\Delta$Yb resulting from the rotation of the head unit 20 due to the distortion of the guide rail 33 and the positional interrelation between the main camera 23, the auxiliary camera 24, and the suction nozzle 25 when the head unit 20 is moved.

According to this embodiment, the six suction nozzles 25 are provided on the head unit 20, and the central processing unit 71 is configured to perform control of correcting the center positions of the six suction nozzles 25 on the basis of the amounts of displacement $\Delta$Xa and $\Delta$Ya regarding the center position of the main camera 23, the amounts of displacement $\Delta$Xb and $\Delta$Yb regarding the center position of the auxiliary camera 24, and the positional interrelation between the main camera 23, the auxiliary camera 24, and the suction nozzles 25 when moving the head unit 20. Thus, also when the head unit 20 has the plurality of suction nozzles 25, the central processing unit 71 performs control of correcting the respective center positions of the suction nozzles 25 and moving the head unit 20, so that the suction nozzles 25 corresponding to the respective mounting positions can be accurately moved with respect to all component mounting operations performed with this head unit 20.

The embodiment disclosed this time must be considered as illustrative in all points and not restrictive. The range of the present invention is shown not by the above description of the embodiment but by the scope of claims for patent, and all modifications within the meaning and range equivalent to the scope of claims for patent are included.

For example, while the present invention is applied to the surface mounter in the aforementioned embodiment, the present invention is not restricted to this. For example, the present invention may alternatively be applied to a dispenser that applies an applying agent such as a solder paste or an adhesive to fix the electronic component to a prescribed applying position on the board, as the example of the "working apparatus for a component or a board" according to the present invention. In other words, this dispenser can perform control of moving a dispenser head (head unit) while correcting the center position of a discharge nozzle on the basis of the first amounts of movement displacement of the actual position coordinates of the center position of a first imaging portion with respect to the theoretical position coordinates thereof, the second amounts of movement displacement of the actual position coordinates of a second imaging portion with respect to the theoretical position coordinates thereof, and the positional interrelation between the first imaging portion, the second imaging portion, and the discharge nozzle (working mechanism portion). Furthermore, the present invention may alternatively be applied to a component testing apparatus that conveys an electronic component suctioned by a suction nozzle (working mechanism portion) to a testing socket arranged at a prescribed position and tests the performance of the electronic component by connecting the electronic component to the testing socket, as the example of the "working apparatus for a component or a board" according to the present invention.

While the present invention is applied when the head unit 20 in which the plurality of (six) suction nozzles 25 are aligned in line in the X-axis direction is moved in the aforementioned embodiment, the present invention is not restricted to this. For example, the present invention may alternatively be applied when a rotary head unit including the plurality of suction nozzles 25 annularly arranged on the lower surface side of the mounting head 22 is moved. In the rotary head unit, the annularly arranged suction nozzles 25 are circularly moved in the horizontal direction on the lower surface side of the mounting head 22, whereby the working position of each of the suction nozzles 25 is changed. Also in this case, the positional relation between the main camera 23 or the auxiliary camera 24 and each of the suction nozzles 25 is known, and hence the present invention can be easily applied.

While the head unit 20 is so configured that the distance L1 (along arrow Y1) of the main camera 23 from the ball screw shaft 31 (X-axis line 600) and the distance L2 (along arrow Y1) of the auxiliary camera 24 from the ball screw shaft 31 are different from each other (L1 < L2) in the aforementioned embodiment, the present invention is not restricted to this. The present invention may alternatively be applied also to control of moving a head unit so configured that the distance of the main camera 23 from the ball screw shaft 31 and the distance of the auxiliary camera 24 from the ball screw shaft 31 are substantially equal to each other (the straight line 500 connecting the main camera 23 and the auxiliary camera 24 to each other is parallel to the X-axis line 600) and the suction nozzles 25 are not arranged on the straight line passing through the main camera 23 and the auxiliary camera 24.

While the present invention is applied to the control of moving the head unit 20 in which each of the suction nozzles 25 is arranged at the position displaced by the distance L3 along arrow Y1 with respect to the center position of the main camera 23 in a region between the main camera 23 and the auxiliary camera 24 as viewed along the direction Z in the aforementioned embodiment, the present invention is not restricted to this. For example, the present invention may alternatively be applied to control of moving a head unit in which the suction nozzles 25 are arranged in a region on the side of the auxiliary camera 24 opposite to the main camera 23 (along arrow X1).

While the correction tables 5a and 5b are prepared by measuring the correction amounts ($\Delta X$, $\Delta Y$) with respect to only the reference marks R in the L-shaped area 106 surrounded by a broken line on the jig plate 105 in the aforementioned embodiment, the present invention is not restricted to this. In other words, correction tables may alternatively be prepared by measuring the correction amounts ($\Delta X$, $\Delta Y$) with respect to all the reference marks R ($P \times Q$ in total) if the storage capacity of the correction data storage portion 72b is sufficiently ensured.

## Claims

1. A working apparatus (100) for a component or a board, comprising:

   a head unit (20) including a first imaging portion (23), a second imaging portion (24), and a working mechanism portion (25) having a suction nozzle or a discharge nozzle arranged at a position other than on a straight line passing through a center of the first imaging portion (23) and a center of the second imaging portion (24) in a plan view;
   a moving mechanism portion (30) so configured that the head unit (20) is movable in the horizontal plane; and
   a control portion (71) performing control of moving the head unit (20) in a horizontal plane, wherein
   the control portion (71) is configured to perform control of correcting a center position of the working mechanism portion (25) on the basis of a first amount of movement displacement of actual position coordinates of a center position of the first imaging portion (23) with respect to theoretical position coordinates of the center position of the first imaging portion (23) resulting from distortion of the moving mechanism portion (30), a second amount of movement displacement of actual position coordinates of a center position of the second imaging portion (24) with respect to theoretical position coordinates of the center position of the second imaging portion (24) resulting from distortion of the moving mechanism portion (30), and a positional interrelation between the first imaging portion (23), the second imaging portion (24), and the working mechanism portion (25) when moving the head unit (20) by the moving mechanism portion (30),
   intersection coordinates at which a circle (700) having a first radius distance between the center position of the first imaging portion (23) and the center position of the working mechanism portion (25) as a radius, employing the center position of the first imaging portion (23) of the actual position coordinates having the first amount of movement displacement as a center and a circle (710) having a second radius distance between the center position of the second imaging portion (24) and the center position of the working mechanism portion (25) as a radius, employing the center position of the second imaging portion (24) of the actual position coordinates having the second amount of movement displacement as a center intersect with each other are the center position of the working mechanism portion (25) obtained on the basis of the positional interrelation, and
   the control portion (71) is configured to perform control of correcting the center position of the working mechanism portion (25) on the basis of a first correction amount being a difference in a first direction between theoretical position coordinates of the center position of the working mechanism portion (25) and the intersection coordinates and a second correction amount being a difference in a second direction orthogonal to the first direction between the theoretical position coordinates of the center position of the working mechanism portion (25) and the intersection coordinates;
   the working apparatus (100) further comprising:

   a correction table (5a, 5b) to which the control portion (71) refers for an amount of displacement of the actual position coordinates of the center position of the first imaging portion (23) with respect to the theoretical position coordinates of the center position of the first imaging portion (23) and an amount of displacement of the actual position coordinates of the center position of the second imaging portion (24) with respect to the theoretical position coordinates of the center position of the second imaging portion (24) when moving the head unit (20) in the horizontal plane, wherein

the control portion (71) is configured to perform control of correcting the center position of the working mechanism portion (25) on the basis of the first amount of movement displacement regarding the center position of the first imaging portion (23) grasped on the basis of the correction table, the second amount of movement displacement regarding the center position of the second imaging portion (24) grasped on the basis of the correction table, and the positional interrelation between the first imaging portion (23), the second imaging portion (24), and the working mechanism portion (25) when moving the head unit (20), and wherein the theoretical position coordinates of the first and second imaging portions are their position coordinates in a case that no distortion is present.

2. The working apparatus (100) for a component or a board according to claim 1, wherein
the control portion (71) is configured to perform control of moving the center position of the working mechanism portion (25) to position coordinates obtained by subtracting the first correction amount in the first direction and the second correction amount in the second direction from the theoretical position coordinates of the center position of the working mechanism portion (25), respectively when moving the head unit (20).

3. The working apparatus (100) for a component or a board according to claim 1 or 2, wherein
the first amount of movement displacement includes a first amount of displacement in the first direction of the actual position coordinates of the center position of the first imaging portion (23) from the theoretical position coordinates of the center position of the first imaging portion (23) and a second amount of displacement in the second direction of the actual position coordinates of the center position of the first imaging portion (23) from the theoretical position coordinates of the center position of the first imaging portion (23),
the second amount of movement displacement includes a third amount of displacement in the first direction of the actual position coordinates of the center position of the second imaging portion (24) from the theoretical position coordinates of the center position of the second imaging portion (24) and a fourth amount of displacement in the second direction of the actual position coordinates of the center position of the second imaging portion (24) from the theoretical position coordinates of the center position of the second imaging portion (24), and
the intersection coordinates serving as the center position of the working mechanism portion (25) are calculated on the basis of a first relational expression satisfied between the intersection coordinates, the theoretical position coordinates of the first imaging portion (23), the first amount of displacement, the second amount of displacement, and the first radius distance and a second relational expression satisfied between the intersection coordinates, the theoretical position coordinates of the second imaging portion (24), the third amount of displacement, the fourth amount of displacement, and the second radius distance.

4. The working apparatus (100) for a component or a board according to claim 3, wherein
the first relational expression is an equation of a circle defined with a coordinate position in the first direction of the intersection coordinates, a first horizontal distance calculated on the basis of a theoretical position coordinate in the first direction of the first imaging portion (23) and the first amount of displacement, a coordinate position in the second direction of the intersection coordinates, a first vertical distance calculated on the basis of a theoretical position coordinate in the second direction of the first imaging portion (23) and the second amount of displacement, and the first radius distance, and
the second relational expression is an equation of a circle defined with a coordinate position in the first direction of the intersection coordinates, a second horizontal distance calculated on the basis of a theoretical position coordinate in the first direction of the second imaging portion (24) and the third amount of displacement, a coordinate position in the second direction of the intersection coordinates, a second vertical distance calculated on the basis of a theoretical position coordinate in the second direction of the second imaging portion (24) and the fourth amount of displacement, and the second radius distance.

5. The working apparatus (100) for a component or a board according to claims 3 or 4, wherein
the intersection coordinates are calculated by solving the first relational expression and the second relational expression together, and
one set of the intersection coordinates effective in control processing for correcting the center position of the working mechanism portion (25) is selected from two sets of the intersection coordinates obtained by solving the first relational expression and the second relational expression together on the basis of the positional interrelation between the first imaging portion (23), the second imaging portion (24), and the working mechanism portion (25).

6. The working apparatus (100) for a component or a board according to any one of the preceding claims, wherein
the control portion (71) is configured to perform control of correcting the center position of the working mechanism portion (25) and moving the head unit (20) on the basis of the first amount of movement displacement, the second amount of movement displacement, and the positional interrelation between the first imaging portion (23), the second imaging portion (24), and the working mechanism portion (25) when an operation on the component (2) or the board (1) is performed with the head unit (20).

7. The working apparatus (100) for a component or a board according to any one of the preceding claims, wherein the control portion (71) is configured to perform control of correcting the center position of the working mechanism portion (25) and moving the head unit (20) on the basis of the first amount of movement displacement, the second amount of movement displacement, and the positional interrelation between the first imaging portion (23), the second imaging portion (24), and the working mechanism portion (25) each time a single operation on the individual component or the individual board is performed.

8. The working apparatus (100) for a component or a board according to any one of the preceding claims, wherein the control portion (71) is configured to perform arithmetic processing for correcting the center position of the working mechanism portion (25) and perform control of moving the head unit (20) on the basis of the first amount of movement displacement, the second amount of movement displacement, and the positional interrelation between the first imaging portion (23), the second imaging portion (24), and the working mechanism portion (25).

9. The working apparatus (100) for a component or a board according to any one of the preceding claims, wherein the correction table includes a first correction table (5a) in which the amount of displacement of the actual position coordinates of the center position of the first imaging portion (23) with respect to the theoretical position coordinates of the center position of the first imaging portion (23) is defined and a second correction table (5b) in which the amount of displacement of the actual position coordinates of the center position of the second imaging portion (24) with respect to the theoretical position coordinates of the center position of the second imaging portion (24) is defined, and

the control portion (71) is configured to perform control of correcting the center position of the working mechanism portion (25) on the basis of the first amount of movement displacement regarding the center position of the first imaging portion (23) calculated with the first correction table, the second amount of movement displacement regarding the center position of the second imaging portion (24) calculated with the second correction table, and the positional interrelation between the first imaging portion (23), the second imaging portion (24), and the working mechanism portion (25) when moving the head unit (20).

10. The working apparatus (100) for a component or a board according to any one of the preceding claims, wherein the moving mechanism portion includes a rail member (33) extending in a first direction to move the head unit (20) along the first direction, and

the control portion (71) is configured to perform control of correcting the center position of the working mechanism portion (25) on the basis of the first amount of movement displacement regarding the center position of the first imaging portion (23) resulting from deformation of the rail member in a second direction orthogonal to the first direction, the second amount of movement displacement regarding the center position of the second imaging portion (24) resulting from the deformation of the rail member in the second direction, and the positional interrelation between the first imaging portion (23), the second imaging portion (24), and the working mechanism portion (25) when moving the head unit (20).

11. The working apparatus (100) for a component or a board according to any one of the preceding claims, wherein a plurality of the working mechanism portions (25) are provided on the head unit (20), and

the control portion (71) is configured to perform control of correcting a center position of each of the plurality of working mechanism portions (25) on the basis of the first amount of movement displacement regarding the center position of the first imaging portion (23), the second amount of movement displacement regarding the center position of the second imaging portion (24), and the positional interrelation between the first imaging portion (23), the second imaging portion (24), and the working mechanism portion (25) when moving the head unit (20).

12. The working apparatus (100) for a component or a board according to any one of the preceding claims, wherein the head unit (20) is configured to be movable along the first direction, the second imaging portion (24) is arranged at a different position in the second direction orthogonal to the first direction with respect to the first imaging portion (23),

the first amount of movement displacement includes a first amount of displacement in the first direction of the actual position coordinates of the center position of the first imaging portion (23) from the theoretical position coordinates of the center position of the first imaging portion (23) and a second amount of displacement in the second direction of the actual position coordinates of the center position of the first imaging portion (23) from the theoretical position coordinates of the center position of the first imaging portion (23),

the second amount of movement displacement includes a third amount of displacement in the first direction of the actual position coordinates of the center position of the second imaging portion (24) from the theoretical position coordinates of the center position of the second imaging portion (24) and a fourth amount of displacement in the second direction of the actual position coordinates of the center position of the second imaging portion (24) from the theoretical position coordinates of the center position of the second imaging portion (24), and

the intersection coordinates serving as the center position of the working mechanism portion (25) are calculated on the basis of a first relational expression satisfied between the intersection coordinates, the theoretical position coordinates of the first imaging portion (23), the first amount of displacement, the second amount of displacement, and the first radius distance and a second relational expression satisfied between the intersection coordinates, the theoretical position coordinates of the second imaging portion (24), the third amount of displacement, the fourth amount of displacement, and the second radius distance.

**Patentansprüche**

1. Eine Arbeitsvorrichtung (100) für ein Bauteil oder eine Platte, die Folgendes umfasst:

eine Kopfeinheit (20) mit einem ersten abbildenden Abschnitt (23), einem zweiten abbildenden Abschnitt (24) und einem Arbeitsmechanismus-Abschnitt (25), der eine Saugdüse oder einer Ausstoßdüse aufweist, die an einer anderen Stelle als auf einer geraden Linie angeordnet sind, die in einer Draufsicht durch ein Zentrum des ersten abbildenden Abschnitts (23) und ein Zentrum des zweiten abbildenden Abschnitts (24) verläuft;

einen Bewegungsmechanismus-Abschnitt (30), der so konfiguriert ist, dass die Kopfeinheit (20) in der horizontalen Ebene bewegbar ist; und

einen Steuerabschnitt (71), der eine Steuerung der Bewegung der Kopfeinheit (20) in einer horizontalen Ebene durchführt, wobei

der Steuerabschnitt (71) konfiguriert ist, um eine Steuerung zur Korrektur einer Mittenposition des Arbeitsmechanismus-Abschnitts (25) durchzuführen, auf der Grundlage eines ersten Betrags einer Bewegungsverschiebung der tatsächlichen Positionskoordinaten einer Mittenposition des ersten abbildenden Abschnitts (23) in Bezug auf theoretische Positionskoordinaten der Mittenposition des ersten abbildenden Abschnitts (23), die aus einer Verformung des Bewegungsmechanismus-Abschnitts (30) resultiert, eines zweiten Betrags einer Bewegungsverschiebung der tatsächlichen Positionskoordinaten einer Mittenposition des zweiten abbildenden Abschnitts (24) in Bezug auf theoretische Positionskoordinaten der Mittenposition des zweiten abbildenden Abschnitts (24), die aus einer Verformung des Bewegungsmechanismus-Abschnitts (30) resultiert, und einer wechselseitigen Positionsbeziehung zwischen dem ersten abbildenden Abschnitt (23), dem zweiten abbildenden Abschnitt (24) und dem Arbeitsmechanismus-Abschnitt (25) beim Bewegen der Kopfeinheit (20) durch den Bewegungsmechanismus-Abschnitt (30),

Schnittpunktkoordinaten, an denen ein Kreis (700) mit einem ersten Radiusabstand zwischen der Mittenposition des ersten abbildenden Abschnitts (23) und der Mittenposition des Arbeitsmechanismus-Abschnitts (25) als Radius, der die Mittenposition des ersten abbildenden Abschnitts (23) der tatsächlichen Positionskoordinaten mit dem ersten Betrag der Bewegungsverschiebung als Mittelpunkt verwendet, und ein Kreis (710) mit einem zweiten Radiusabstand zwischen der Mittenposition des zweiten abbildenden Abschnitts (24) und der Mittenposition des Arbeitsmechanismus-Abschnitts (25) als Radius, der die Mittenposition des zweiten abbildenden Abschnitts (24) der tatsächlichen Positionskoordinaten mit dem zweiten Betrag der Bewegungsverschiebung als Mittelpunkt, sich schneiden, die Mittenposition des Arbeitsmechanismus-Abschnitts (25) sind, erhalten auf der Grundlage der wechselseitigen Positionsbeziehung, und wobei

der Steuerabschnitt (71) konfiguriert ist, um eine Steuerung zur Korrektur der Mittenposition des Arbeitsmechanismus-Abschnitts (25) auf folgender Grundlage durchzuführen: auf der Grundlage eines ersten Korrekturbetrags, der eine Differenz in einer ersten Richtung zwischen theoretischen Positionskoordinaten der Mittenposition des Arbeitsmechanismus-Abschnitts (25) und den Schnittpunktkoordinaten ist, und eines zweiten Korrekturbetrags, der eine Differenz in einer zweiten Richtung orthogonal zur ersten Richtung zwischen den theoretischen Positionskoordinaten der Mittenposition des Arbeitsmechanismus-Abschnitts (25) und den Schnittpunktkoordinaten ist;

wobei die Arbeitsvorrichtung (100) ferner Folgendes umfasst:

eine Korrekturtabelle (5a, 5b), auf die sich der Steuerabschnitt (71) bezieht für einen Betrag der Verschiebung der tatsächlichen Positionskoordinaten der Mittenposition des ersten abbildenden Abschnitts (23) in Bezug auf die theoretischen Positionskoordinaten der Mittenposition des ersten abbildenden Abschnitts (23), und für einen Betrag der Verschiebung der tatsächlichen Positionskoordinaten der Mittenposition des zweiten abbildenden Abschnitts (24) in Bezug auf die theoretischen Positionskoordinaten der Mittenposition des zweiten abbildenden Abschnitts (24) beim Bewegen der Kopfeinheit (20) in der horizontalen Ebene, wobei

der Steuerabschnitt (71) konfiguriert ist, um eine Steuerung zur Korrektur der Mittenposition des Arbeitsmechanismus-Abschnitts (25) auf folgender Grundlage durchzuführen: auf der Grundlage des ersten Betrags der Bewegungsverschiebung bezüglich der Mittenposition des ersten abbildenden Abschnitts (23), der auf der Grundlage der Korrekturtabelle erfasst wird, des zweiten Betrags der Bewegungsverschiebung bezüglich der Mittenposition des zweiten abbildenden Abschnitts (24), der auf der Grundlage der Korrekturtabelle erfasst wird, und der wechselseitigen Positionsbeziehung zwischen dem ersten abbildenden Abschnitt (23), dem zweiten abbildenden Abschnitt (24) und dem Arbeitsmechanismus-Abschnitt (25) beim Bewegen der Kopfeinheit (20), und

wobei die theoretischen Positionskoordinaten des ersten und zweiten abbildenden Abschnitts dessen Positionskoordinaten sind, wenn keine Verzerrung vorliegt.

2. Die Arbeitsvorrichtung (100) für ein Bauteil oder eine Platte nach Anspruch 1, wobei
der Steuerabschnitt (71) konfiguriert ist, um eine Steuerung der Bewegung der Mittenposition des Arbeitsmechanismus-Abschnitts (25) zu Positionskoordinaten durchzuführen, die durch Subtrahieren des ersten Korrekturbetrags in der ersten Richtung und des zweiten Korrekturbetrags in der zweiten Richtung von den theoretischen Positionskoordinaten der Mittenposition des Arbeitsmechanismus-Abschnitts (25) jeweils beim Bewegen der Kopfeinheit (20) erhalten werden.

3. Die Arbeitsvorrichtung (100) für ein Bauteil oder eine Platte nach Anspruch 1 oder 2, wobei
der erste Betrag der Bewegungsverschiebung Folgendes enthält: einen ersten Betrag der Verschiebung in der ersten Richtung der tatsächlichen Positionskoordinaten der Mittenposition des ersten abbildenden Abschnitts (23) ausgehend von den theoretischen Positionskoordinaten der Mittenposition des ersten abbildenden Abschnitts (23) und einen zweiten Betrag der Verschiebung in der zweiten Richtung der tatsächlichen Positionskoordinaten der Mittenposition des ersten abbildenden Abschnitts (23) ausgehend von den theoretischen Positionskoordinaten der Mittenposition des ersten abbildenden Abschnitts (23),

der zweite Betrag der Bewegungsverschiebung Folgendes enthält: einen dritten Betrag der Verschiebung in der ersten Richtung der tatsächlichen Positionskoordinaten der Mittenposition des zweiten abbildenden Abschnitts (24) ausgehend von den theoretischen Positionskoordinaten der Mittenposition des zweiten abbildenden Abschnitts (24) und einen vierten Betrag der Verschiebung in der zweiten Richtung der tatsächlichen Positionskoordinaten der Mittenposition des zweiten abbildenden Abschnitts (24) ausgehend von den theoretischen Positionskoordinaten der Mittenposition des zweiten abbildenden Abschnitts (24), und wobei

die Schnittpunktkoordinaten, die als Mittenposition des Arbeitsmechanismus-Abschnitts (25) dienen, auf der Grundlage eines ersten relationalen Ausdrucks berechnet werden, der zwischen den Schnittpunktkoordinaten, den theoretischen Positionskoordinaten des ersten abbildenden Abschnitts (23), dem ersten Betrag der Verschiebung, dem zweiten Betrag der Verschiebung und dem ersten Radiusabstand erfüllt ist, und auf der Grundlage eines zweiten relationalen Ausdruck, der zwischen den Schnittpunktkoordinaten, den theoretischen Positionskoordinaten des zweiten abbildenden Abschnitts (24), dem dritten Betrag der Verschiebung, dem vierten Betrag der Verschiebung und dem zweiten Radiusabstand erfüllt ist.

4. Die Arbeitsvorrichtung (100) für ein Bauteil oder eine Platte nach Anspruch 3, wobei
der erste relationale Ausdruck eine Gleichung eines Kreises ist, der definiert ist mit einer Koordinatenposition in der ersten Richtung der Schnittpunktkoordinaten, einem ersten horizontalen Abstand, der auf der Grundlage einer theoretischen Positionskoordinate in der ersten Richtung des ersten abbildenden Abschnitts (23) und des ersten Verschiebungsbetrags berechnet wird, einer Koordinatenposition in der zweiten Richtung der Schnittpunktkoordinaten, einem ersten vertikalen Abstand, der auf der Grundlage einer theoretischen Positionskoordinate in der zweiten Richtung des ersten abbildenden Abschnitts (23) und des zweiten Verschiebungsbetrags berechnet wird, und dem ersten Radiusabstand, und wobei

der zweite relationale Ausdruck eine Gleichung eines Kreises ist, der definiert ist mit einer Koordinatenposition in der ersten Richtung der Schnittpunktkoordinaten, einem zweiten horizontalen Abstand, der auf der Grundlage einer theoretischen Positionskoordinate in der ersten Richtung des zweiten abbildenden Abschnitts (24) und des dritten Verschiebungsbetrags berechnet wird, einer Koordinatenposition in der zweiten Richtung der Schnittpunktkoordinaten, einem zweiten vertikalen Abstand, der auf der Grundlage einer theoretischen Positionskoordinate in der zweiten Richtung des zweiten abbildenden Abschnitts (24) und des vierten Verschiebungsbetrags berechnet wird, und dem zweiten Radiusabstand.

**5.** Die Arbeitsvorrichtung (100) für ein Bauteil oder eine Platte nach Anspruch 3 oder 4, wobei
die Schnittpunktkoordinaten berechnet werden, indem der erste relationale Ausdruck und der zweite relationale Ausdruck zusammen gelöst werden und wobei
ein Satz an Schnittpunktkoordinaten, die bei der Steuerung des Verarbeitens zur Korrektur der Mittenposition des Arbeitsmechanismus-Abschnitts (25) wirksam sind, aus zwei Sätzen an Schnittpunktkoordinaten ausgewählt wird, die durch gemeinsames Lösen des ersten relationalen Ausdrucks und des zweiten relationalen Ausdrucks erhalten werden auf der Grundlage der Positionsbeziehung zwischen dem ersten abbildenden Abschnitt (23), dem zweiten abbildenden Abschnitt (24) und dem Arbeitsmechanismus-Abschnitt (25).

**6.** Die Arbeitsvorrichtung (100)für ein Bauteil oder eine Platte nach irgendeinem der vorstehenden Ansprüche, wobei der Steuerabschnitt (71) konfiguriert ist, um eine Steuerung durchzuführen zur Korrektur der Mittenposition des Arbeitsmechanismus-Abschnitts (25) und zum Bewegen der Kopfeinheit (20) auf der folgenden Grundlage: auf der Grundlage des ersten Betrags der Bewegungsverschiebung, des zweiten Betrags der Bewegungsverschiebung und der wechselseitigen Positionsbeziehung zwischen dem ersten abbildenden Abschnitt (23), dem zweiten abbildenden Abschnitt (24) und dem Arbeitsmechanismus-Abschnitt (25), wenn eine Operation an dem Bauteil (2) oder der Platte (1) mit der Kopfeinheit (20) durchgeführt wird.

**7.** Die Arbeitsvorrichtung (100) für ein Bauteil oder eine Platte nach irgendeinem der vorstehenden Ansprüche, wobei der Steuerabschnitt (71) konfiguriert ist, um eine Steuerung durchzuführen zur Korrektur der Mittenposition des Arbeitsmechanismus-Abschnitts (25) und zum Bewegen der Kopfeinheit (20) auf der Grundlage des ersten Betrags der Bewegungsverschiebung, des zweiten Betrags der Bewegungsverschiebung und der wechselseitigen Positionsbeziehung zwischen dem ersten abbildenden Abschnitt (23), dem zweiten abbildenden Abschnitt (24) und dem Arbeitsmechanismus-Abschnitt (25), wenn jeweils eine einzelne Operation an der einzelnen Komponente oder der einzelnen Platte ausgeführt wird.

**8.** Die Arbeitsvorrichtung (100) für ein Bauteil oder eine Platte nach irgendeinem der vorstehenden Ansprüche, wobei der Steuerabschnitt (71) konfiguriert ist, um eine arithmetische Verarbeitung zur Korrektur der Mittenposition des Arbeitsmechanismus-Abschnitts (25) durchzuführen und um eine Steuerung der Bewegung der Kopfeinheit (20) durchzuführen auf der Grundlage des ersten Betrags der Bewegungsverschiebung, des zweiten Betrags der Bewegungsverschiebung und der wechselseitigen Positionsbeziehung zwischen dem ersten abbildenden Abschnitt (23), dem zweiten abbildenden Abschnitt (24) und dem Arbeitsmechanismus-Abschnitt (25).

**9.** Die Arbeitsvorrichtung (100) für ein Bauteil oder eine Platte nach irgendeinem der vorstehenden Ansprüche, wobei die Korrekturtabelle Folgendes enthält: eine erste Korrekturtabelle (5a), in der der Betrag der Verschiebung der tatsächlichen Positionskoordinaten der Mittenposition des ersten abbildenden Abschnitts (23) in Bezug auf die theoretischen Positionskoordinaten der Mittenposition des ersten abbildenden Abschnitts (23) definiert ist, und eine zweite Korrekturtabelle (5b), in der der Betrag der Verschiebung der tatsächlichen Positionskoordinaten der Mittenposition des zweiten abbildenden Abschnitts (24) in Bezug auf die theoretischen Positionskoordinaten der Mittenposition des zweiten abbildenden Abschnitts (24) definiert ist, und wobei
der Steuerabschnitt (71) konfiguriert ist, um eine Steuerung durchzuführen zur Korrektur der Mittenposition des Arbeitsmechanismus-Abschnitts (25) auf der Grundlage des ersten Betrags der Bewegungsverschiebung bezüglich der Mittenposition des ersten abbildenden Abschnitts (23), der mit der ersten Korrekturtabelle berechnet wird, des zweiten Betrags der Bewegungsverschiebung bezüglich der Mittenposition des zweiten abbildenden Abschnitts (24), der mit der zweiten Korrekturtabelle berechnet wird, und der wechselseitigen Positionsbeziehung zwischen dem ersten abbildenden Abschnitt (23), dem zweiten abbildenden Abschnitt (24) und dem Arbeitsmechanismus-Abschnitt (25) beim Bewegen der Kopfeinheit (20).

**10.** Die Arbeitsvorrichtung (100) für ein Bauteil oder eine Platte nach irgendeinem der vorstehenden Ansprüche, wobei der Bewegungsmechanismus-Abschnitt ein Schienenelement (33) umfasst, das in einer ersten Richtung verläuft, um die Kopfeinheit (20) entlang der ersten Richtung zu bewegen, und wobei
der Steuerabschnitt (71) konfiguriert ist, um eine Steuerung durchzuführen zur Korrektur der Mittenposition des Arbeitsmechanismus-Abschnitts (25) auf der folgenden Grundlage: des ersten Betrags der Bewegungsverschiebung bezüglich der Mittenposition des ersten abbildenden Abschnitts (23), die aus einer Verformung des Schienenelements in einer zweiten Richtung orthogonal zur ersten Richtung resultiert, des zweiten Betrags der Bewegungsverschiebung bezüglich der Mittenposition des zweiten abbildenden Abschnitts (24), der sich aus der Verformung des Schienenelements in der zweiten Richtung ergibt, und der wechselseitigen Positionsbeziehung zwischen dem ersten abbildenden Abschnitt (23), dem zweiten abbildenden Abschnitt (24) und dem Arbeitsmechanismus-Abschnitt (25) beim Bewegen der Kopfeinheit (20).

**11.** Die Arbeitsvorrichtung (100) für ein Bauteil oder eine Platte nach irgendeinem der vorstehenden Ansprüche, wobei eine Vielzahl an Arbeitsmechanismus-Abschnitten (25) an der Kopfeinheit (20) vorgesehen sind und wobei der Steuerabschnitt (71) konfiguriert ist, um eine Steuerung durchzuführen zur Korrektur einer Mittenposition jedes der mehreren Arbeitsmechanismus-Abschnitte (25) auf der Grundlage des ersten Betrags der Bewegungsverschiebung bezüglich der Mittenposition des ersten abbildenden Abschnitts (23), des zweiten Betrags der Bewegungsverschiebung bezüglich der Mittenposition des zweiten abbildenden Abschnitts (24) und der wechselseitigen Positionsbeziehung zwischen dem ersten abbildenden Abschnitt (23), dem zweiten abbildenden Abschnitt (24) und dem Arbeitsmechanismus-Abschnitt (25) beim Bewegen der Kopfeinheit (20).

**12.** Die Arbeitsvorrichtung (100) für ein Bauteil oder eine Platte nach irgendeinem der vorstehenden Ansprüche, wobei die Kopfeinheit (20) so konfiguriert ist, dass sie entlang der ersten Richtung beweglich ist, der zweite abbildende Abschnitt (24) an einer anderen Position in der zweiten Richtung orthogonal zur ersten Richtung bezüglich des ersten abbildenden Abschnitts (23) angeordnet ist, der erste Betrag der Bewegungsverschiebung Folgendes enthält: einen ersten Betrag der Verschiebung in der ersten Richtung der tatsächlichen Positionskoordinaten der Mittenposition des ersten abbildenden Abschnitts (23) ausgehend von den theoretischen Positionskoordinaten der Mittenposition des ersten abbildenden Abschnitts (23) und einen zweiten Betrag der Verschiebung in der zweiten Richtung der tatsächlichen Positionskoordinaten der Mittenposition des ersten abbildenden Abschnitts (23) ausgehend von den theoretischen Positionskoordinaten der Mittenposition des ersten abbildenden Abschnitts (23), der zweite Betrag der Bewegungsverschiebung Folgendes enthält: einen dritten Betrag der Verschiebung in der ersten Richtung der tatsächlichen Positionskoordinaten der Mittenposition des zweiten abbildenden Abschnitts (24) ausgehend von den theoretischen Positionskoordinaten der Mittelpunktposition des zweiten abbildenden Abschnitts (24) und einen vierten Betrag der Verschiebung in der zweiten Richtung der tatsächlichen Positionskoordinaten der Mittenposition des zweiten abbildenden Abschnitts (24) ausgehend von den theoretischen Positionskoordinaten der Mittenposition des zweiten abbildenden Abschnitts (24), und wobei die Schnittpunktköordinaten, die als die Mittenposition des Arbeitsmechanismus-Abschnitts (25) dienen, auf der Grundlage eines ersten relationalen Ausdrucks berechnet werden, der zwischen den Schnittpunktkoordinaten, den theoretischen Positionskoordinaten des ersten abbildenden Abschnitts (23), dem ersten Betrag der Verschiebung, dem zweiten Betrag der Verschiebung und dem ersten Radiusabstand erfüllt ist, und eines zweiten relationalen Ausdrucks, der zwischen den Schnittpunktkoordinaten, den theoretischen Positionskoordinaten des zweiten abbildenden Abschnitts (24), dem dritten Betrag der Verschiebung, dem vierten Betrag der Verschiebung und dem zweiten Radiusabstand erfüllt ist.

## Revendications

**1.** Un appareil de travail (100) pour un composant ou une carte, comprenant :

une unité de tête (20) comprenant une première portion d'imagerie (23), une deuxième portion d'imagerie (24), et une portion mécanisme de travail (25) présentant une buse d'aspiration ou une buse de décharge disposées à une position autre que sur une ligne droite passant par un centre de la première portion d'imagerie (23) et un centre de la deuxième portion d'imagerie (24) selon une vue en plan ;
une portion mécanisme mobile (30) configurée de telle manière que l'unité de tête (20) est mobile dans le plan horizontal ; et
une portion de commande (71) effectuant la commande du déplacement de l'unité de tête (20) dans un plan horizontal, sachant que
la portion de commande (71) est configurée pour effectuer une commande de correction d'une position de centre de la portion mécanisme de travail (25) sur la base d'une première quantité de déplacement de mouvement de coordonnées de position réelle d'une position de centre de la première portion d'imagerie (23) par rapport aux coordonnées de position théorique de la position de centre de la première portion d'imagerie (23), résultant d'une distorsion de la portion mécanisme mobile (30), d'une deuxième quantité de déplacement de mouvement de coordonnées de position réelle d'une position de centre de la deuxième portion d'imagerie (24) par rapport aux coordonnées de position théorique de la position de centre de la deuxième portion d'imagerie (24), résultant de la distorsion de la portion mécanisme mobile (30), et d'une interrelation de position entre la première portion d'imagerie (23), la deuxième portion d'imagerie (24) et la portion mécanisme de travail (25) lors du déplacement de l'unité de tête (20) par la portion mécanisme mobile (30),
des coordonnées d'intersection, auxquelles un cercle (700), ayant une première distance de rayon entre la position de centre de la première portion d'imagerie (23) et la position de centre de la portion mécanisme de travail (25) en tant que rayon, utilisant la position de centre de la première portion d'imagerie (23) des coordonnées de position réelle ayant la première quantité de déplacement de mouvement en tant que centre, et un cercle (710) ayant une deuxième distance de rayon entre la position de centre de la deuxième portion d'imagerie (24) et la position de centre de la portion mécanisme de travail (25) en tant que rayon, employant la position de centre de la deuxième portion d'imagerie (24) des coordonnées de position réelle ayant la deuxième quantité de déplacement de mouvement en tant que centre, se croisent, sont la position de centre de la portion mécanisme de travail (25) obtenue sur la base de l'interrelation positionnelle, et que

la portion de commande (71) est configurée pour effectuer une commande de correction de la position de centre de la portion mécanisme de travail (25) sur la base d'une première quantité de correction étant une différence dans une première direction entre les coordonnées de position théorique de la position de centre de la portion mécanisme de travail (25) et les coordonnées d'intersection, et d'une deuxième quantité de correction étant une différence dans une deuxième direction orthogonale à la première direction entre les coordonnées de position théorique de la position de centre de la portion mécanisme de travail (25) et les coordonnées d'intersection ;

l'appareil de travail (100) comprenant en outre :

une table de correction (5a, 5b) à laquelle la portion de commande (71) fait référence à une quantité de déplacement des coordonnées de position réelle de la position de centre de la première portion d'imagerie (23) par rapport aux coordonnées de position théorique de la position de centre de la première portion d'imagerie (23), et à une quantité de déplacement des coordonnées de position réelle de la position de centre de la deuxième portion d'imagerie (24) par rapport aux coordonnées de position théorique de la position de centre de la deuxième portion d'imagerie (24) lorsque l'unité de tête (20) est déplacée dans le plan horizontal, sachant que

la portion de commande (71) est configurée pour effectuer une commande de correction de la position de centre de la portion mécanisme de travail (25) sur la base de la première quantité de déplacement de mouvement concernant la position de centre de la première portion d'imagerie (23) saisie sur la base de la table de correction, de la deuxième quantité de déplacement de mouvement concernant la position de centre de la deuxième portion d'imagerie (24) saisie sur la base de la table de correction, et de l'interrelation positionnelle entre la première portion d'imagerie (23), la deuxième portion d'imagerie (24), et la portion mécanisme de travail (25) lors du déplacement de l'unité de tête (20), et

sachant que les coordonnées de position théorique des première et deuxième portions d'imagerie sont leurs coordonnées de position dans le cas où il n'y a pas de distorsion.

2. L'appareil de travail (100) pour un composant ou une carte d'après la revendication 1, sachant que
la portion de commande (71) est configurée pour effectuer une commande de déplacement de la position de centre de la portion mécanisme de travail (25) vers des coordonnées de position obtenues en soustrayant la première quantité de correction dans la première direction et la deuxième quantité de correction dans la deuxième direction des coordonnées de position théorique de la position de centre de la portion mécanisme de travail (25), respectivement lors du déplacement de l'unité de tête (20).

3. L'appareil de travail (100) pour un composant ou une carte d'après la revendication 1 ou 2, sachant que
la première quantité de déplacement de mouvement inclut : une première quantité de déplacement dans la première direction des coordonnées de position réelle de la position de centre de la première portion d'imagerie (23) à partir des coordonnées de position théorique de la position de centre de la première portion d'imagerie (23) et une deuxième quantité de déplacement dans la deuxième direction des coordonnées de position réelle de la position de centre de la première portion d'imagerie (23) à partir des coordonnées de position théorique de la position de centre de la première portion d'imagerie (23),
la deuxième quantité de déplacement de mouvement inclut : une troisième quantité de déplacement dans la première direction des coordonnées de position réelle de la position de centre de la deuxième portion d'imagerie (24) à partir des coordonnées de position théorique de la position de centre de la deuxième portion d'imagerie (24), et une quatrième quantité de déplacement dans la deuxième direction des coordonnées de position réelle de la position de centre de la deuxième portion d'imagerie (24) à partir des coordonnées de position théorique de la position de centre de la deuxième portion d'imagerie (24) ; et que
les coordonnées d'intersection servant de position de centre de la portion mécanisme de travail (25) sont calculées sur la base : d'une première expression relationnelle satisfaite entre les coordonnées d'intersection, les coordonnées de position théorique de la première portion d'imagerie (23), la première quantité de déplacement, la deuxième quantité de déplacement, et la première distance de rayon, et d'une deuxième expression relationnelle satisfaite entre les coordonnées d'intersection, les coordonnées de position théorique de la deuxième portion d'imagerie (24), la troisième quantité de déplacement, la quatrième quantité de déplacement et la deuxième distance de rayon.

**4.** L'appareil de travail (100) pour un composant ou une carte d'après la revendication 3, sachant que
la première expression relationnelle est une équation d'un cercle défini avec une position de coordonnées dans la première direction des coordonnées d'intersection, une première distance horizontale calculée sur la base d'une coordonnée de position théorique dans la première direction de la première portion d'imagerie (23) et de la première quantité de déplacement, une position de coordonnées dans la deuxième direction des coordonnées d'intersection, une première distance verticale calculée sur la base d'une coordonnée de position théorique dans la deuxième direction de la première portion d'imagerie (23) et de la deuxième quantité de déplacement, et la première distance de rayon, et que
la deuxième expression relationnelle est une équation d'un cercle défini avec une position de coordonnées dans la première direction des coordonnées d'intersection, une deuxième distance horizontale calculée sur la base d'une coordonnée de position théorique dans la première direction de la deuxième portion d'imagerie (24) et de la troisième quantité de déplacement, une position de coordonnées dans la deuxième direction des coordonnées d'intersection, une deuxième distance verticale calculée sur la base d'une coordonnée de position théorique dans la deuxième direction de la deuxième portion d'imagerie (24) et de la quatrième quantité de déplacement, et la deuxième distance de rayon.

**5.** L'appareil de travail (100) pour un composant ou une carte d'après les revendications 3 ou 4, sachant que
les coordonnées d'intersection sont calculées en résolvant ensemble la première expression relationnelle et la deuxième expression relationnelle, et que
un ensemble des coordonnées d'intersection, efficace dans le traitement de commande de correction de la position de centre de la portion mécanisme de travail (25), est sélectionné parmi deux ensembles des coordonnées d'intersection obtenues en résolvant ensemble la première expression relationnelle et la deuxième expression relationnelle sur la base de l'interrelation positionnelle entre la première portion d'imagerie (23), la deuxième portion d'imagerie (24) et la portion mécanisme de travail (25).

**6.** L'appareil de travail (100) pour un composant ou une carte d'après l'une quelconque des revendications précédentes, sachant que
la portion de commande (71) est configurée pour effectuer une commande de correction de la position de centre de la portion mécanisme de travail (25) et de déplacement de l'unité de tête (20) sur la base de la première quantité de déplacement de mouvement, de la deuxième quantité de déplacement de mouvement et de l'interrelation positionnelle entre la première portion d'imagerie (23), la deuxième portion d'imagerie (24) et la portion mécanisme de travail (25) lorsqu'une opération sur le composant (2) ou la carte (1) est effectuée avec l'unité de tête (20).

**7.** L'appareil de travail (100) pour un composant ou une carte d'après l'une quelconque des revendications précédentes, sachant que
la portion de commande (71) est configurée pour effectuer une commande de correction de la position de centre de la portion mécanisme de travail (25) et de déplacement de l'unité de tête (20) sur la base de la première quantité de déplacement de mouvement, de la deuxième quantité de déplacement de mouvement et de l'interrelation positionnelle entre la première portion d'imagerie (23), la deuxième portion d'imagerie (24) et la portion mécanisme de travail (25) chaque fois qu'une seule opération est effectuée sur le composant individuel ou la carte individuelle.

**8.** L'appareil de travail (100) pour un composant ou une carte d'après l'une quelconque des revendications précédentes, sachant que
la portion de commande (71) est configurée pour effectuer un traitement arithmétique de correction de la position de centre de la portion mécanisme de travail (25) et pour effectuer une commande de déplacement de l'unité de tête (20) sur la base de la première quantité de déplacement de mouvement, de la deuxième quantité de déplacement de mouvement et de l'interrelation positionnelle entre la première portion d'imagerie (23), la deuxième portion d'imagerie (24) et la portion mécanisme de travail (25).

**9.** L'appareil de travail (100) pour un composant ou une carte d'après l'une quelconque des revendications précédentes, sachant que
la table de correction inclut : une première table de correction (5a) dans laquelle est définie la quantité de déplacement des coordonnées de position réelle de la position de centre de la première portion d'imagerie (23) par rapport aux coordonnées de position théorique de la position de centre de la première portion d'imagerie (23), et une deuxième table de correction (5b) dans laquelle est définie la quantité de déplacement des coordonnées de position réelle de la position de centre de la deuxième portion d'imagerie (24) par rapport aux coordonnées de position théorique de la position de centre de la deuxième portion d'imagerie (24), et que

la portion de commande (71) est configurée pour effectuer une commande de correction de la position de centre de la portion mécanisme de travail (25) sur la base de la première quantité de déplacement de mouvement concernant la position de centre de la première portion d'imagerie (23) calculée avec la première table de correction, de la deuxième quantité de déplacement de mouvement concernant la position de centre de la deuxième portion d'imagerie (24) calculée avec la deuxième table de correction, et de l'interrelation de position entre la première portion d'imagerie (23), la deuxième portion d'imagerie (24) et la portion mécanisme de travail (25) lors du déplacement de l'unité de tête (20).

10. L'appareil de travail (100) pour un composant ou une carte d'après l'une quelconque des revendications précédentes, sachant que

la portion de mécanisme de déplacement comprend un élément rail (33) s'étendant dans une première direction pour déplacer l'unité de tête (20) le long de la première direction, et que

la portion de commande (71) est configurée pour effectuer une commande de correction de la position de centre de la portion mécanisme de travail (25) sur la base de la première quantité de déplacement de mouvement concernant la position de centre de la première portion d'imagerie (23) résultant d'une déformation de l'élément rail dans une deuxième direction orthogonale à la première direction, de la deuxième quantité de déplacement de mouvement concernant la position de centre de la deuxième portion d'imagerie (24) résultant de la déformation de l'élément rail dans la deuxième direction, et de l'interrelation positionnelle entre la première portion d'imagerie (23), la deuxième portion d'imagerie (24) et la portion mécanisme de travail (25) lors du déplacement de l'unité de tête (20).

11. L'appareil de travail (100) pour un composant ou une carte d'après l'une quelconque des revendications précédentes, sachant que

une pluralité de portions mécanisme de travail (25) est prévue sur l'unité de tête (20), et que

la portion de commande (71) est configurée pour effectuer une commande de correction d'une position de centre de chacune parmi la pluralité de portions mécanisme de travail (25) sur la base de la première quantité de déplacement de mouvement concernant la position de centre de la première portion d'imagerie (23), de la deuxième quantité de déplacement de mouvement concernant la position de centre de la deuxième portion d'imagerie (24), et de l'interrelation positionnelle entre la première portion d'imagerie (23), la deuxième portion d'imagerie (24) et la portion mécanisme de travail (25) lors du déplacement de l'unité de tête (20).

12. L'appareil de travail (100) pour un composant ou une carte d'après l'une quelconque des revendications précédentes, sachant que

l'unité de tête (20) est configurée pour être mobile dans la première direction, la deuxième portion d'imagerie (24) est disposée à une position différente dans la deuxième direction orthogonale à la première direction par rapport à la première portion d'imagerie (23),

la première quantité de déplacement de mouvement inclut : une première quantité de déplacement dans la première direction des coordonnées de position réelle de la position de centre de la première portion d'imagerie (23) à partir des coordonnées de position théorique de la position de centre de la première portion d'imagerie (23), et une deuxième quantité de déplacement dans la deuxième direction des coordonnées de position réelle de la position de centre de la première portion d'imagerie (23) à partir des coordonnées de position théorique de la position de centre de la première portion d'imagerie (23),

la deuxième quantité de déplacement de mouvement inclut : une troisième quantité de déplacement dans la première direction des coordonnées de position réelle de la position de centre de la deuxième portion d'imagerie (24) à partir des coordonnées de position théorique de la position de centre de la deuxième portion d'imagerie (24), et une quatrième quantité de déplacement dans la deuxième direction des coordonnées de position réelle de la position de centre de la deuxième portion d'imagerie (24) à partir des coordonnées de position théorique de la position de centre de la deuxième portion d'imagerie (24) ; et que

les coordonnées d'intersection servant de position de centre de la portion mécanisme de travail (25) sont calculées sur la base : d'une première expression relationnelle satisfaite entre les coordonnées d'intersection, les coordonnées de position théorique de la première portion d'imagerie (23), la première quantité de déplacement, la deuxième quantité de déplacement, et la première distance de rayon, et une deuxième expression relationnelle satisfaite entre les coordonnées d'intersection, les coordonnées de position théorique de la deuxième portion d'imagerie (24), la troisième quantité de déplacement, la quatrième quantité de déplacement et la deuxième distance de rayon.

FIG.1

FIG.2

## FIG.3

| CONTROLLER | |
| --- | --- |
| CENTRAL PROCESSING UNIT (CPU) | 71 |
| STORAGE PORTION | 72 |
| OPERATING PROGRAM STORAGE PORTION | 72a |
| CORRECTION DATA STORAGE PORTION | 72b |
| CORRECTION TABLE | 5a |
| CORRECTION TABLE | 5b |
| IMAGE PROCESSING PORTION | 73 |
| MOTOR CONTROL PORTION | 74 |
| EXTERNAL INPUT/ OUTPUT PORTION | 75 |

- BOARD CAMERA 50
- COMPONENT CAMERA 60
- MAIN CAMERA 23
- AUXILIARY CAMERA 24
- SERVOMOTOR 32 ···X– AXIS
- SERVOMOTOR 42 ···Y– AXIS
- SERVOMOTOR 26 ···Z– AXIS
- SERVOMOTOR 27 ···R– AXIS
- SERVOMOTOR ···BOARD CONVEYANCE AXIS
- 20 HEAD UNIT
- VARIOUS OPERATING BUTTONS 76
- VARIOUS SENSORS 77

## FIG.4

HEAD UNIT DURING MOVEMENT IN DIRECTION

## FIG.5

$$( Xu2 - (Xm + \Delta Xa))^2 + ( Yu2 - (Ym + \Delta Ya))^2 = Rm^2$$
$$( Xu2 - (Xs + \Delta Xb))^2 + ( Yu2 - (Ys + \Delta Yb))^2 = Rs^2$$

$Xu2 - (Xm + \Delta Xa)$ : FIRST HORIZONTAL DISTANCE
$Yu2 - (Ym + \Delta Ya)$ : FIRST VERTICAL DISTANCE
$Xu2 - (Xs + \Delta Xb)$ : SECOND HORIZONTAL DISTANCE
$Yu2 - (Ys + \Delta Yb)$ : SECOND VERTICAL DISTANCE

## FIG.6   JIG PLATE FOR DISTORTION MEASUREMENT
### USED TO ACQUIRE DISTORTION OF APPARATUS

## FIG.7

| CORRECTION TABLE IN WHICH CORRECTION AMOUNTS (AMOUNTS OF DISPLACEMENT) WITH RESPECT TO THEORETICAL COORDINATES ACQUIRED WITH MAIN CAMERA ARE STORED | | | | | | |
|---|---|---|---|---|---|---|

5a

| ROW (X-COORDINATE) | 1 | 2 | ... | p | ... | P |
|---|---|---|---|---|---|---|
| CORRECTION AMOUNTS | $\Delta X_{11}, \Delta Y_{11}$ | $\Delta X_{12}, \Delta Y_{12}$ | ... | $\Delta X_{1p}, \Delta Y_{1p}$ | ... | $\Delta X_{1P}, \Delta Y_{1P}$ |
| COLUMN (Y-COORDINATE) | 1 | 2 | ... | q | ... | Q |
| CORRECTION AMOUNTS (AMOUNTS OF DISPLACEMENT) | | $\Delta X_{21}, \Delta Y_{21}$ | ... | $\Delta X_{q1}, \Delta Y_{q1}$ | ... | $\Delta X_{Q1}, \Delta Y_{Q1}$ |

| CORRECTION TABLE IN WHICH CORRECTION AMOUNTS (AMOUNTS OF DISPLACEMENT) WITH RESPECT TO THEORETICAL COORDINATES ACQUIRED WITH AUXILIARY CAMERA ARE STORED | | | | | | |
|---|---|---|---|---|---|---|

5b

| ROW (X-COORDINATE) | 1 | 2 | ... | p | ... | P |
|---|---|---|---|---|---|---|
| CORRECTION AMOUNTS | $\Delta X_{11}, \Delta Y_{11}$ | $\Delta X_{12}, \Delta Y_{12}$ | ... | $\Delta X_{1p}, \Delta Y_{1p}$ | ... | $\Delta X_{1P}, \Delta Y_{1P}$ |
| COLUMN (Y-COORDINATE) | 1 | 2 | ... | q | ... | Q |
| CORRECTION AMOUNTS (AMOUNTS OF DISPLACEMENT) | | $\Delta X_{21}, \Delta Y_{21}$ | ... | $\Delta X_{q1}, \Delta Y_{q1}$ | ... | $\Delta X_{Q1}, \Delta Y_{Q1}$ |

## FIG.8

FLOW OF CONTROL PROCESSING PERFORMED BY CENTRAL PROCESSING UNIT OF SURFACE MOUNTER TO PREPARE CORRECTION TABLE

START

S1 INITIALIZE COUNTER (p = 1, q = 1)

S2 MOVE HEAD UNIT BY ONE REFERENCE MARK IN PRESCRIBED DIRECTION (DIRECTION X, DIRECTION Y)

S3 IMAGE REFERENCE MARK BY MAIN (AUXILIARY) CAMERA

S4 ACQUIRE CORRECTION AMOUNTS ($\Delta X$, $\Delta Y$)

S5 COMPLETE IMAGING OF ALL REFERENCE MARKS IN FIRST ROW? — No → S6 p = p + 1

Yes

S7 COMPLETE IMAGING OF ALL REFERENCE MARKS IN FIRST COLUMN? — No → S8 p = 1, q = q + 1

Yes

S9 PREPARE AND STORE CORRECTION TABLE

END

*FIG.9*

FLOW OF CONTROL PROCESSING PERFORMED BY CENTRAL
PROCESSING UNIT TO MOUNT ELECTRONIC COMPONENT

```
                        ( START )
                            │
                            ▼◄──────────────────────┐
                                            S21      │
    ┌──────────────────────────────────────────┐    │
    │ ACQUIRE MOUNTING POSITION COORDINATES     │    │
    └──────────────────────────────────────────┘    │
                            │                 S22    │
                            ▼                        │
    ┌──────────────────────────────────────────┐    │
    │        CALCULATE CORRECTION AMOUNTS        │    │
    │   (Mv(dx) = Xu2 − Xu1, Mv(dy) = Yu2 − Yu1) │   │
    │   REGARDING CENTER POSITION OF SUCTION     │    │
    │ NOZZLE ON THE BASIS OF CORRECTION TABLE    │    │
    └──────────────────────────────────────────┘    │
                            │                 S23    │
                            ▼                        │
    ┌──────────────────────────────────────────┐    │
    │   MOVE HEAD UNIT TO MOUNTING POSITION      │    │
    │     WHILE TAKING CORRECTION AMOUNTS        │    │
    │     Mv(dx), Mv(dy) INTO CONSIDERATION      │    │
    └──────────────────────────────────────────┘    │
                            │                 S24    │
                            ▼                        │
    ┌──────────────────────────────────────────┐    │
    │ MOUNT ELECTRONIC COMPONENT ON PRINTED BOARD│    │
    └──────────────────────────────────────────┘    │
                            │        S25             │
                            ▼                  Yes   │
                        ◄ DATA ON ►─────────────────┘
                        ◄ MOUNTING REMAIN? ►
                            │
                            │ No
                            ▼
                        ( END )
```

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005347555 A
- EP 1583412 A1
- US 2009252400 A1